# EUROPEAN PATENT APPLICATION

(11) **EP 2 940 743 A1**
(43) Date of publication of application: **04.11.2015**
(21) Application number: 13867392.6
(22) Date of filing: 27.12.2013
(51) Int. Cl.: H01L 33/50

(54) **LIGHT EMITTING DEVICE**

(30) Priority: 28.12.2012 JP 2012286797
(71) Applicant: Konica Minolta, Inc., Tokyo 100-7015 (JP)
(72) Inventor: WASHIZU Takashi, Chiyoda-Ku Tokyo 100-7015 (JP)
(74) Representative: Henkel, Breuer & Partner
(86) International application number: PCT/JP2013/085111
(87) International publication number: WO 2014/104295

(57) **Abstract**

The purpose of the present invention is to provide a light emitting device which emits light having less chromaticity unevenness for a long period of time. In order to achieve the above-mentioned purpose, an LED device (a light emitting device) is configured to comprise: a light emitting member which has a package and an LED chip mounted on the package; and a wavelength conversion/light diffusion member which is fitted on the light extraction surface side of the light emitting member and has a glass substrate, and a wavelength conversion layer and a light diffusion layer that are formed on the glass substrate. The wavelength conversion layer contains phosphor particles, and the light diffusion layer contains light diffusion particles and a curbed product of an organosilicon compound.

## Description

### Technical Field

The present invention relates to a light emitting device.

### Background Art

Conventionally, there is a light emitting device that incorporates various kinds of light emitting elements. Among others, many white LED devices are developed which use an LED (Light Emitting Diode) chip as a light source, and white LED devices are put in practical use as various kinds of illumination devices. An example of the white LED device, there is a device that uses a blue LED chip as a light source, combines blue light from the blue LED chip with yellow fluorescent light emitted from a fluorescent material receiving the blue light, thereby obtaining white light. Besides, also there is a device that uses an ultraviolet LED chip as a light source, mixes blue light, green light, and red light emitted from fluorescent materials receiving ultraviolet light, thereby obtaining white light.

In such white LED devices, a wavelength conversion layer, which is obtained by dispersing fluorescent material particles in transparent resin, is disposed near the LED chip. However, a specific gravity of the fluorescent material particles contained in the wavelength conversion layer is larger than a specific gravity of the transparent resin. Because of this, during a forming period of the wavelength conversion layer, the fluorescent material particles precipitate before the transparent resin is hardened, so that concentration of the fluorescent material particles does not become even. If the fluorescent material concentration is uneven, chromaticity unevenness is prone to occur in the light emitted from the LED device. Further, there is a problem that difference between the chromaticity of light emitted in a front surface direction of the LED device and the chromaticity of light emitted in an oblique direction of the LED device becomes large.

Because of this, it is under study that a light diffusion film is disposed on the wavelength conversion layer of the white LED device. However, a conventional light diffusion film is formed of resin; accordingly, there is a problem that the light diffusion film is prone to deteriorate because of the light and heat emitted from the LED chip. Also, especially, the light diffusion film is prone to deteriorate in an LED device that has high light emission brightness and in an LED device that is used outdoors.

On the other hand, in the fields of a liquid crystal television with an area larger than an LED device, a projection television and the like, many light diffusion members for diffusing light are proposed. For example, it is proposed to use a glass substrate containing light scattering material therein as a light guide of a liquid crystal television (patent document 1). Besides, it is also proposed to apply a light diffusion member, which includes a glass substrate and a light diffusion layer formed on the glass substrate, to a screen of a projection television (patent document 2). The light diffusion layer of the light diffusion member of the patent document 2 contains light diffusion particles and binders.

### Citation List

### Patent Literature

PLT1: JP-A-2011-99899
PLT2: JP-A-2007-127858

### Summary of Invention

### Technical Problem

To curb chromaticity unevenness of the emitted light from the above white LED device, it is conceivable to apply the light diffusion member described in the patent document 1 or patent document 2 to the white LED device. However, as to the light diffusion member of the patent document 1, during a period of producing a glass substrate, it is necessary to add light scattering material into the glass.

Besides, the binder of the light diffusion layer of the patent document 2 can be organic resin or hardened material of metal alkoxide. However, if the organic resin is used for the binder, there is a risk that the binder could deteriorate because of the heat and light emitted from the LED chip. On the other hand, if the hardened material of the metal alkoxide is used for the binder, it is concerned that adhesion between the light diffusion layer and other layers (e.g., an adhesive layer and the glass substrate) does not become sufficient depending on kinds of the metal alkoxide and the light diffusion layer peels off at interfaces between them. Further, it is also concerned that the light diffusion layer cannot follow deformation of the glass substrate depending kinds of the metal alkoxide and cracks occur in the diffusion layer because of expansion and the like of the glass substrate. Accordingly, it is difficult to apply the light diffusion member described in the patent document 1 or patent document 2 to the white LED device as they are.

The present invention has been made in light of such situations, and it is an object of the present invention to provide a light emitting device that has a little chromaticity unevenness in the emitted light for a long time.

### Solution to Problem

To achieve the above object, the present invention is a light emitting device that comprises: a light emitting member that has a package and a light emitting element mounted on the package; and a wavelength conversion▪light diffusion member that is mounted on a light output surface of the light emitting member and has a glass substrate, a wave length conversion layer and a light diffusion layer which are formed on the glass substrate; wherein the wavelength conversion layer contains a fluorescent material particle, and the light diffusion layer contains a light diffusion particle and hardened material of organic silicon compound.

In the above light emitting device, it is preferable that the organic silicon compound is formed of polymer of 3 functional silane compound and 4 functional silane compound, and a polymerization ratio of the 3 functional silane compound and the 4 functional silane compound is 3:7 to 7:3.

Besides, in the above light emitting device, it is preferable that the organic silicon compound is formed of polymer of 2 functional silane compound and 3 functional silane compound, and a polymerization ratio of the 2 functional silane compound and the 3 functional silane compound is 1:9 to 4:6.

Besides, in the above light emitting device, it is preferable that the organic silicon compound is formed of polymer of 2 functional silane compound, 3 functional silane compound, and 4 functional silane compound, a polymerization ratio of the 2 functional silane compound and the 3 functional silane compound is 1:9 to 4:6, and a polymerization ratio of the 4 functional silane compound to polymer of the 2 functional silane compound and the 3 functional silane compound is 9:1 to 7:3.

Besides, in the above light emitting device, it is preferable that the light diffusion particle is at least one kind selected from the group of titanium oxide, barium sulfate, barium titanate, boron nitride, zinc oxide, and aluminum oxide.

Besides, in the above light emitting device, it is preferable that the light diffusion layer contains metal oxide microparticles whose average primary particle diameter is under 100 nm.

Besides, in the above light emitting device, it is preferable that the metal oxide microparticles are at least one kind selected from the group of zirconium oxide, titanium oxide, cerium oxide, silicon oxide, niobium oxide, and zinc oxide.

Besides, in the above light emitting device, it is preferable that the light diffusion layer contains clay mineral.

Besides, in the above light emitting device, it is preferable that the clay mineral is aluminum silicate compound.

Besides, in the above light emitting device, it is preferable that the light diffusion layer contains hardened material of metal alkoxide or metal chelate that contains a metal element (except for Si) having a valence of 2 or more.

Besides, in the above light emitting device, it is preferable that the wavelength conversion layer contains hardened material of organic silicon compound.

Besides, in the above light emitting device, it is preferable that the wavelength conversion layer contains transparent resin.

### Advantageous Effects of Invention

In the light emitting device according to the present invention, the binder of the light diffusion layer is hardened material of organic silicon compound; accordingly, the light diffusion layer is less likely to be deteriorated by heat and light. Further, the adhesion between the light diffusion layer and the glass substrate, etc is high, and there is a little peeling at interfaces among these. Besides, the wavelength conversion layer having a high density is formed on the glass substrate; accordingly, the wavelength conversion layer, whose concentration of the fluorescent material particles is even, is obtained, so that light having even chromaticity is obtained.

Therefore, according to the present invention, it is possible to output the light having the even chromaticity from the light emitting device for a long time.

### Brief Description of Drawings

[Fig. 1] is a schematic cross-sectional view showing an example of an LED device according to an embodiment of the present invention.
[Fig. 2] is a schematic cross-sectional view showing another example of an LED device according to an embodiment of the present invention.
[Fig. 3] is a schematic cross-sectional view showing another example of an LED device according to an embodiment of the present invention.
[Fig. 4] is a schematic cross-sectional view showing another example of an LED device according to an embodiment of the present invention.
[Fig. 5] is a schematic cross-sectional view showing an example of a wavelength conversion▪light diffusion member according to an embodiment of the present invention.
[Fig. 6] is a schematic cross-sectional view showing another example of a wavelength conversion▪light diffusion member according to an embodiment of the present invention.
[Fig. 7] is a schematic cross-sectional view showing another example of a wavelength conversion▪light diffusion member according to an embodiment of the present invention.
[Fig. 8] is a view for describing part of a production step of an LED device according to an embodiment of the present invention.

### Description of Embodiments

Hereinafter, as an embodiment of a light emitting device that incorporates various kinds of light emitting elements, an LED device using an LED chip as a light source is described as an example.

### 1. LED device

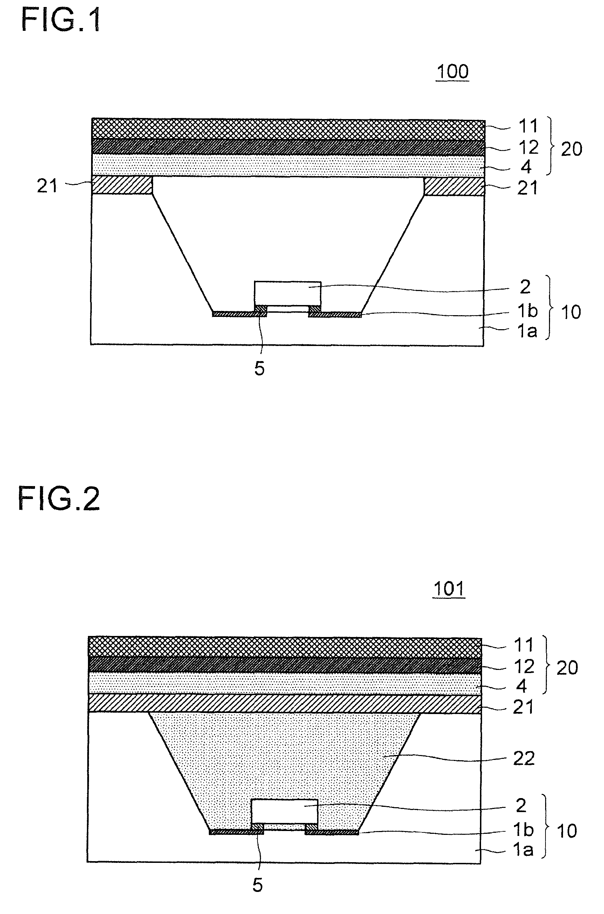

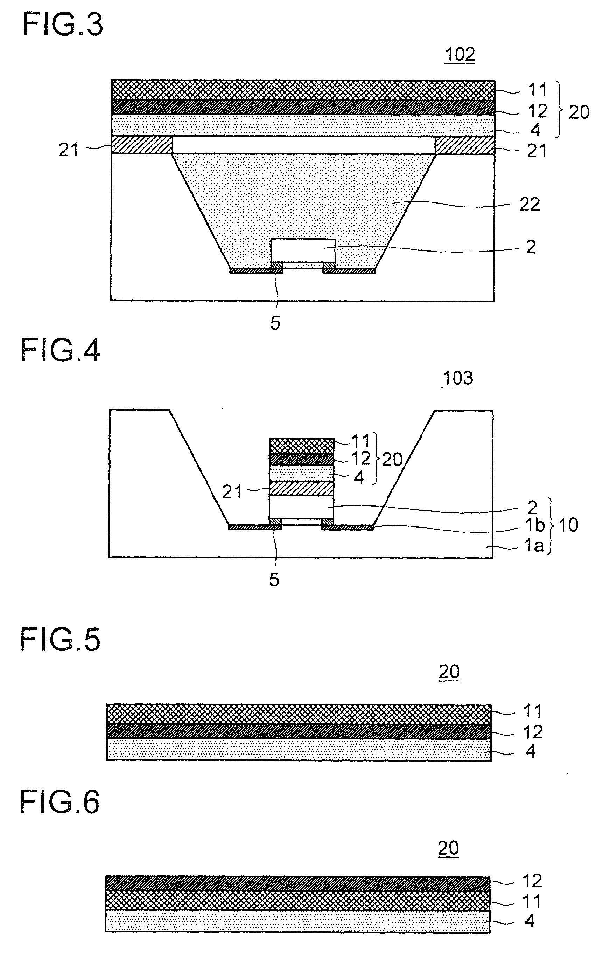

Structural examples of LED devices according to four embodiments of the present invention are shown in schematic cross-sectional views of Fig. 1 to Fig. 4, respectively. The LED devices 100 to 103 shown in Fig. 1 to Fig. 4 each include: a light emitting member 10 that emits light; a wavelength conversion▪light diffusion member 20 that applies wavelength conversion to the light emitted from the light emitting member 10 to output and diffuse fluorescent light, thereby evening chromaticity of the light emitted from the LED devices 100 to 103; and an adhesive layer 21 that attaches the light emitting member 10 and the wavelength conversion▪ light diffusion member 20 to each other. Further, the LED devices 101, 102 shown in Fig. 2 and Fig. 3 each include a seal member 22 that seals a package 1. The light emitting member 10 includes the package 1 (1a and 1b) and an LED chip 2 mounted on the package 1. The wavelength conversion-light diffusion member 20 includes a glass substrate 11, a light diffusion layer 12, and a wavelength conversion layer 4 that emits fluorescent light. In the LED devices 100 to 103, the wavelength conversion▪ light diffusion member 20 is disposed to oppose a light output surface of the light emitting member 10.

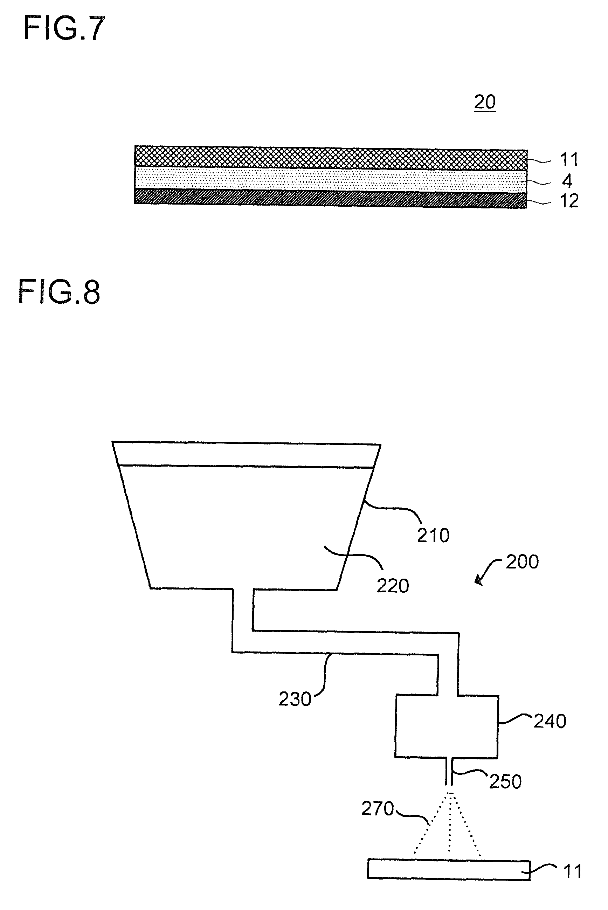

A lamination order of the wavelength conversion▪light diffusion member 20 is not limited: the light diffusion layer 12 and the wavelength conversion layer 4 can be directly or indirectly formed on the glass substrate 11, and there are lamination orders as shown in Fig. 5 to Fig. 7. In Fig. 5, the glass substrate 11, the light diffusion layer 12, and the wavelength conversion layer 4 are laminated in this order. In Fig. 6, the light diffusion layer 12, the glass substrate 11, and the wavelength conversion layer 4 are laminated in this order. In Fig. 7, the glass substrate 11, the wavelength conversion layer 4, and the light diffusion layer 12 are laminated in this order. As to the wavelength conversion-light diffusion members 20 in Figs. 5 to 7, the adhesive layer 21 may be disposed on whichever surface, and there are six patterns in all in which the wavelength conversion▪light diffusion member 20 in each of Figs. 5 to 7 is attached to the package 1.

Structures of the LED devices obtained from these patterns are represented in (a) to (f). In the meantime, the adhesive layer and the seal member are skipped. In any structure, the effect of the present invention is obtained. However, considering wear resistance, the structure (a) or (c), in which the glass substrate is located outside, is preferable.
(a) the glass substrate/the light diffusion layer/the wavelength conversion layer/the LED chip (the wavelength conversion▪light diffusion member in Fig. 5 is used).
(b) the light diffusion layer/the glass substrate/the wavelength conversion layer/the LED chip (the wavelength conversion▪light diffusion member in Fig. 6 is used).
(c) the glass substrate/the wavelength conversion layer/the light diffusion layer/the LED chip (the wavelength conversion▪light diffusion member in Fig. 7 is used).
(d) the wavelength conversion layer/the light diffusion layer/the glass substrate/the LED chip (the wavelength conversion▪light diffusion member in Fig. 5 is used).
(e) the wavelength conversion layer/the glass substrate/the light diffusion layer/the LED chip (the wavelength conversion-light diffusion member in Fig. 6 is used).
(f) the light diffusion layer/the wavelength conversion layer/the glass substrate/the LED chip (the wavelength conversion▪light diffusion member in Fig. 7 is used).

In the meantime, in Figs. 1 to 4, the above (a) structure is obtained in such a way that the wavelength conversion-light diffusion member 20 in Fig. 5 is used as an example and the adhesive layer 21 is disposed on the wavelength conversion layer 4.

In the LED devices 100 to 103 of Fig. 1 to Fig. 4, a binder of the light diffusion layer 12 is hardened material of organic silicon compound.

As described above, if the binder of the light diffusion layer 12 is organic resin, the light diffusion layer 12 is deteriorated by light and heat from the LED chip and the like. Further, in Fig. 5 and Fig. 6, adhesion between the light diffusion layer 12 and the glass substrate 11 is insufficient, and in Fig. 7, adhesion between the light diffusion layer 12 and the wavelength conversion layer 4 is insufficient, so that they are likely to peel from each other at an interface between them. Because of this, chromaticity unevenness occurs in the emitted light from the LED device and light output efficiency from the LED device declines.

In contrast to this, in the LED devices 100 to 103 of Fig. 1 to Fig. 4, the binder of the light diffusion layer 12 is hardened material of organic silicon compound; accordingly, the light diffusion layer 12 is unlikely to deteriorate. Besides, silicon contained in the binder (organic silicon compound) and a hydroxyl group, etc. of a coated surface form siloxane bonding. Because of this, adhesion between the light diffusion layer 12 and the glass substrate 11 or adhesion between the light diffusion layer 12 and the wavelength conversion layer 4 is good, so that they are unlikely to peel at the interface between them.

Further, in the LED devices 100 to 103 of Fig. 1 to Fig. 4, the wavelength conversion layer 4 is formed on the glass substrate 11.

As described above, if the wavelength conversion layer 4 is packed in a concave portion of the package 1, a specific gravity of the fluorescent material particles contained in the wavelength conversion layer 4 is larger than a specific gravity of the transparent resin; accordingly, during a period of forming the wavelength conversion layer 4, the fluorescent material particles precipitate before the transparent resin is hardened, so that the concentration of the fluorescent material particles does not become even. If the fluorescent material concentration is uneven, the chromaticity unevenness is prone to occur in the light emitted from the LED device. Further, difference between chromaticity of light emitted in a front surface direction of the LED device and chromaticity of light emitted in an oblique direction of the LED device becomes large.

In contrast to this, in the LED devices 100 to 103 of Fig. 1 to Fig. 4, to form the wavelength conversion layer 4 onto the glass substrate 11, composition for forming of a high-density wavelength conversion layer is applied. Therefore, the wavelength conversion layer having a higher density is formed; accordingly, the wavelength conversion layer 4, in which the concentration of the fluorescent material particles is even, is obtained, and the LED devices 100 to 103, which emit the light of the even chromaticity, are obtained.

As described above, in the LED devices 100 to 103 of Fig. 1 to Fig. 4, it is possible to curb the chromaticity unevenness of the emitted light for a long time.

Next, details of respective constituent members of the LED devices 100 to 103 of Fig. 1 to Fig. 4 are described.

### ▪ Package

The package 1 fulfills a function of supporting the LED chip 2 and a function of electrically connecting the LED chip 2 to an external electrode (not shown). As shown in Fig. 1 to Fig. 4, the package 1 can be a member or the like that has the substrate 1a and the metal portion 1b.

A shape of the substrate 1a is not especially limited, but may be a flat plate shape, or may be a concave shape as shown in Figs. 1 to 4. A shape of the concave portion is not especially limited, but may be a conical trapezoidal shape as shown in Figs. 1 to 4, or may be a pyramidal trapezoidal shape, a cylindrical shape, a polygonal pole shape or the like.

It is preferable that the substrate 1a preferably has isolation and heat resistance, and is preferably formed of ceramic resin or heat resistant resin. As examples of the heat resistant resin, there are liquid crystal polymer, polyphenylenesulfide, aromatic nylon, epoxy resin, hard silicone resin, polyphthalamide and the like.

The substrate 1a may contain inorganic filler. The inorganic filler can be titanium oxide, zinc oxide, aluminum, silica, barium titanate, calcium phosphate, calcium carbonate, white carbon, talc, magnesium carbonate, boron nitride, glass fiber or the like.

The metal portion 1b is formed of metal such as silver or the like, and plays a role of electrically connecting an external electrode (not shown) and the LED chip 2 to each other. Besides, the metal portion 1b may play a role of reflecting the light from the LED chip 2 and the fluorescent light from the wavelength conversion layer 4 toward the light output surface of the light emitting member.

### ▪ LED chip

The LED chip 2 is a semiconductor light emitting element that is electrically connected to the metal potion 1b of the package 1 to convert electric power into light.

A structure of the LED chip 2 is not especially limited. In a case where the LED chip 2 is an element which emits blue light, the LED chip 2 can be a laminated body of a n-GaN-based compound semiconductor layer (clad layer), an InGaN-based compound semiconductor layer (light emitting layer), a p-GaN-based compound semiconductor layer (clad layer), and a transparent electrode layer. The LED chip 2 can have a light emitting surface of 200 to 300 µm × 200 to 300 µm, for example. Besides, a height of the LED chip 2 is usually about 50 to 200 µm. As to the LED devices 100 to 103 shown in Fig. 1 to Fig. 4, only one LED chip 2 is disposed in the package 1. However, a plurality of LED chips 2 may be disposed in the package 1.

A wavelength of the light emitted from the LED chip 2 is not especially limited. The LED chip 2 may be, for example, an element that emits blue light (light of about 420 nm to about 485 nm) or an element that emits ultraviolet light.

The LED chip 2 may be connected to the metal portion 1b of the package via a wiring. Besides, as shown in Figs. 1 to 4, the LED chip 2 may be connected to the metal portion 1b via a protrusion electrode 5. A form of the LED chip 2 being connected to the metal portion 1b via the wiring is called a wire bonding type, and a form of the LED chip 2 being connected to the metal portion 1b via the protrusion electrode 5 is called a flip chip type.

### ▪ Wavelength conversion layer

The wavelength conversion layer 4 receives the light (excitation light) emitted from the LED chip 2 to emit fluorescent light. Excitation light and the fluorescent light mix with each other, whereby color of the light emitted from the light output surface of the light emitting member 10 becomes a desired color. For example, if the light from the LED chip 2 is blue and the fluorescent light emitted from the fluorescent material contained in the wavelength conversion layer 4 is yellow, the light from the LED devices 100 to 103 becomes white.

The wavelength conversion layer 4 contains the fluorescent material particles and the binders. The fluorescent material particles contained in the wavelength conversion layer 4 may be particles which are excited by the light emitted from the LED chip 2 to emit the fluorescent light that has a wavelength different from the light emitted from the LED chip 2. For example, as examples of the fluorescent material particles that emit yellow fluorescent light, there are YAG (yttrium·aluminum·garnet) fluorescent material and the like. The YAG fluorescent material receives the blue light (wavelength 420 nm to 485 nm) emitted from the LED chip to emit the yellow light (wavelength 550 nm to 650 nm).

As to the fluorescent material particles, for example, 1) a suitable amount of flux (fluoride such as ammonium fluoride or the like) is mixed with mixed raw material having a predetermined composition and pressed, which is used as a formed body. 2) The obtained formed body is packed into a crucible, baked for 2 to 5 hours in a temperature range of 1350 to 1450°C in air to produce a sintered body, whereby the fluorescent material particles are obtained.

The mixed raw material having the predetermined composition is obtained by sufficiently mixing oxides such as Y, Gd, Ce, Sm, Al, La, Ga and the like, or sufficiently mixing compounds, which become oxide easily at a high temperature, at a stoichiometric ratio. Besides, as to the mixed raw material having the predetermined composition, 1) coprecipitation oxide is obtained by mixing solution produced by dissolving rare earth elements of Y, Gd, Ce, Sm in acid at a stoichiometric ratio with oxalic acid. 2) The coprecipitation oxide is mixed with aluminum oxide or gallium oxide, whereby the mixed raw material having the predetermined composition is also obtained.

The kind of the fluorescent material is not limited to the YAG fluorescent material, but for example, may be another fluorescent material such as non-garnet-based fluorescent material or the like that does not contain Ce.

It is preferable that an average particle diameter of the fluorescent material particles is 1 µm to 50 µm, and 10 µm to 30 µm is more preferable. The larger the particle diameter of fluorescent material particles is, the higher the light emission efficiency (wavelength conversion efficiency) becomes. On the other hand, if the particle diameter of the fluorescent material particles is too large, a gap occurring at the interface between the fluorescent material particles and the binders becomes large in the wavelength conversion layer 4. In this way, strength of a hardened film of the wavelength conversion layer 4 declines, and a gas becomes prone to invade into the LED chip 2 from an outside of the LED devices 100 to 103. It is possible to measure the average particle diameter of the fluorescent material particle by using a Coulter counter method, for example.

The binder contained in the wavelength conversion layer 4 is not especially limited, but may be transparent resin or light-transmissive ceramic. As examples of the transparent resin that can be used as the binder, there are silicone resins such as epoxy-modified silicone resin, alkyd-modified silicone resin, acryl-modified silicone resin, polyester-modified silicone resin, methyl silicone resin, phenyl silicone resin and the like; epoxy resin; acrylic resin; methacrylic resin; urethane resin and the like.

In a case where the binder contained in the wavelength conversion layer 4 is transparent resin, a thickness of the wavelength conversion layer 4 is usually about 25 µm to about 5 mm. The thickness of the wavelength conversion layer 4 means the maximum thickness of the wavelength conversion layer 4 formed on the glass substrate 11. The thickness of the wavelength conversion layer 4 is measured by LASER HOLOGAGE. Here, the amount of the fluorescent material particles contained in the wavelength conversion layer 4 is usually about 5 to about 15 mass% to the total mass of the wavelength conversion layer 4.

On the other hand, as examples of the light-transmissive ceramic that can be used as the binder, there is hardened material of organic silicon compound. The hardened material of organic silicon compound can be the same as binder (e.g., hardened material of polysiloxane or polysilazane) contained in the light diffusion layer described later.

In a case where the binder contained in the wavelength conversion layer 4 is light-transmissive ceramic, the thickness of the wavelength conversion layer 4 is not especially limited, but 15 µm to 300 µm is preferable, and 20 to 100 µm is further preferable. If the thickness of the wavelength conversion layer 4 is too thick, there is a risk that cracks could occur in the wavelength conversion layer 4 (especially, the light-transmissive ceramic binder). On the other hand, if the thickness of the wavelength conversion layer 4 is too thin, there is a possibility that the wavelength conversion layer 4 could not sufficiently contain the fluorescent material particles and sufficient fluorescent light could not be obtained. Here, it is preferable that the total amount of the fluorescent material particles contained in the wavelength conversion layer 4 is 50 to 95 mass% to the total mass of the wavelength conversion layer 4. If the amount of the fluorescent material particles is small, sufficient fluorescent light is not obtained. On the other hand, if the amount of the fluorescent material particles is excessive, the amount of the binder decreases relatively, and the strength of the wavelength conversion layer 4 becomes low.

In the case where the binder contained in the wavelength conversion layer 4 is light-transmissive ceramic, the wavelength conversion layer 4 may contain inorganic particles or clay mineral particles when necessary.

If the wavelength conversion layer 4 contains clay mineral particles, the strength of the wavelength conversion layer 4 rises easily. As examples of the clay mineral, there are smectite group clay minerals such as natural or synthetic hectorite, saponite, stevensite, beidellite, montmorillonite, nontronite, bentonite and the like; swelling mica group clay minerals such as Na-type tetrasilicic fluoromica, Li-type tetrasilicic fluoromica, Na-type fluor-taeniolite, Li-type fluor-taeniolite and the like; vermiculite, kaolinite, and aluminum silicate compound, or mixtures of these. As to the clay mineral, a surface may be modified (surface treatment) by using ammonium salt or the like.

The aluminum silicate compound described here is hydrated aluminum silicate that uses silicon (Si), aluminum (Al), oxygen (O) and hydrogen (H) as main constituent elements and is assembled by many Si-O-Al bonds. For example, there is imogolite. And, it is preferable that the aluminum silicate compound has a tube shape whose outer diameter is 2.0 to 2.5 nm, inner diameter is 1.0 to 1.5 nm, and length is a few hundreds of nanometers.

It is preferable that the amount of the clay mineral particles contained in the wavelength conversion layer 4 is 0.3 to 20 mass% to the total mass of the wavelength conversion layer 4, and 0.5 to 15 mass% is more preferable. If the concentration of the clay mineral particles is under 0.5 mass%, there is a case where the strength of the wavelength conversion layer 4 does not rise sufficiently. On the other hand, if the concentration of the clay mineral particles exceeds 20 mass%, the amount of the fluorescent material particles becomes less relatively, and there is a risk that sufficient fluorescent light could not be obtained.

If the wavelength conversion layer 4 contains inorganic particles, the strength of the wavelength conversion layer 4 rises. As examples of the inorganic particles, there are oxide microparticles and the like such as silicon oxide, titanium oxide, zinc oxide, aluminum oxide, zirconium oxide and the like. Surfaces of the inorganic particles may be treated with silane coupling agent or titanium coupling agent. Adhesion between the inorganic particles and the light-transmissive ceramic rises because of the surface treatment. Besides, the inorganic particles can be porous inorganic particles that have a large specific surface area.

As to a particle diameter of the inorganic particles, from the viewpoint of smoothness of the wavelength conversion layer, it is preferable that an average primary particle diameter is 0.001 µm or larger to 50 µm or smaller. The average primary particle diameter in the present embodiment is a D50 value measured by a laser diffraction particle size distribution analyzer. As examples of the laser diffraction particle size distribution measurement device, there are a laser diffraction particle size distribution measurement device from Shimadzu Corporation and the like.

It is preferable that the amount of the inorganic particles contained in the wavelength conversion layer 4 is 0.5 to 70 mass% to the total amount of the wavelength conversion layer 4, 0.5 to 65 mass% is more preferable, and 1.0 to 60 mass% is further preferable. If the amount of the inorganic particles is under 0.5 mass%, there is a risk where the strength of the wavelength conversion layer 4 does not rise sufficiently. On the other hand, if the amount of the inorganic particles exceeds 70 mass%, the amount of the fluorescent material particles becomes less relatively, and there is a risk that sufficient fluorescent light could not be obtained.

### ▪ Glass substrate

The glass substrate 11 of the wavelength conversion-light diffusion member 20 plays a role of supporting the light diffusion layer 12 and a role of protecting the light emitting member 10 from outside impact, moisture, gas and the like. It is preferable that a thickness of the glass substrate 11 is 50 to 500 µm, and 50 to 200 µm is more preferable. If the thickness of the glass substrate is 50 µm or more, it is possible to sufficiently protect the light emitting member 10 by using the glass substrate. On the other hand, if the thickness of the glass substrate exceeds 200 µm, the LED devices 100 to 103 become large in size.

It is preferable that a visible light transmittance of the glass substrate 11 measured in conformity with JIS K7361-1 (1997) is 85% or more, and 90% or more is more preferable. If the visible light transmittance of the glass substrate 11 is 85% or more, the light output efficiency of the LED device 100 becomes good. The kind of the glass substrate 11 is not especially limited, but from the viewpoint of impact resistance and the like, high-strength glass is preferable.

### ▪ Light diffusion layer

The light diffusion layer 12 is a layer that diffuses the light emitted from the LED chip 2 and the light obtained by the wavelength conversion layer 4 converting the light emitted from the LED chip 2. The light diffusion layer 12 contains light diffusion particles and hardened material (binder) of organic silicon compound. The light diffusion layer 12 may contain metal oxide microparticles, clay mineral, and hardened material of metal alkoxide or metal chelate.

Minuscule concaves and convexes are formed on a surface of the light diffusion layer 12. These concaves and convexes are formed by metal oxide microparticles, for example, but may be formed by using another method. It is preferable that an arithmetic average roughness of the surface of the light diffusion layer 12 provided by the concaves and convexes is 0.005 to 5.0 µm. The arithmetic average roughness (Ra) is defined by JIS B0601 (2001) and the measurement is performed by using the WYKOHD3000, namely, a white light interferometer, from Veeco Instruments Inc. or the like.

The surface roughness of the light diffusion layer 12 is represented by an average value of measurements on an 30% area of the total area of the light diffusion layer 12 which are obtained by measuring a few arbitrary points on the light diffusion layer 12 produced on the glass substrate 11.

In the case of the LED devices having the above (a), (c) to (e) structures, the adhesive layer 21 or the wavelength conversion layer 4 is formed on the light diffusion layer 12; accordingly, the adhesion with these layers is necessary. Because of this, as described above, by setting the arithmetic average roughness of the surface of the light diffusion layer 12 at 0.005 to 5.0 µm, an anchor effect is obtained among these layers; accordingly, the adhesion improves. If the surface roughness is lower than a lower limit value of the arithmetic average roughness, there is a risk that the anchor effect could not be obtained sufficiently. On the other hand, if the surface roughness is higher than an upper limit value of the arithmetic average roughness, it is concerned that air voids could be contained in the concave and convex portions during a production period, and there is a risk that the adhesion could decline.

If the adhesion declines, the layers could peel from each other at the interfaces among them. In this case, chromaticity unevenness occurs in the emitted light from the LED device and the light output efficiency of the LED device declines. In contrast to this, if there is a concave and convex structure having a predetermined roughness on the surface of the light diffusion layer 12, the anchor effect is obtained between the light diffusion layer 12 and the adhesive layer 21 and the adhesion is good; accordingly, it is possible to curb the chromaticity unevenness of the emitted light and also possible to prevent the decline of the light output efficiency for a long time.

Besides, a thickness of the light diffusion layer 12 is not especially limited, but 200 nm to 30 µm is preferable, and 500 nm to 10 µm is more preferable. If the thickness of the light diffusion layer 12 is too thin, there is a possibility that sufficient light diffusiveness could not be obtained. On the other hand, if the thickness of the light diffusion layer 12 is too thick, there is a risk that cracks could occur in the light diffusion layer 12.

It is preferable that a visible light transmittance of the light diffusion layer 12 measured in conformity with JIS K7361-1 (1997) is 85% or more, and 90% or more is more preferable. If the visible light transmittance of the light diffusion layer is 85% or more, the light output efficiency of the LED devices 100 to 103 becomes good.

### (Light diffusion particles)

The light diffusion particles contained in the light diffusion layer 12 are not especially limited if they are particles high in light diffusiveness. It is preferable that a total reflectivity of the light diffusion particles is 80% or more, and 90% or more is further preferable. The total reflectivity of the light diffusion particles is measurable by using the U4100, namely, a Hitachi spectrophotometer, from Hitachi High-Technologies Corporation.

As examples of the light diffusion particles, there are zinc oxide (ZnO), barium titanate (BaTiO₃), barium sulfate (BaSO₄), titanium oxide (TiO₂), boron nitride (BrN), magnesium oxide (MgO), calcium carbonate (CaCO₃), aluminum oxide (Al₂O₃), barium sulfate (BaO), zirconium oxide (ZrO₂) and the like. From the viewpoint of light diffusiveness, handleability and the like, it is more preferable that the light diffusion particles are zinc oxide, barium titanate, barium sulfate, titanium oxide, boron nitride, or aluminum oxide. The light diffusion layer12 may contain only one kind of light diffusion particles, or may contain two or more kinds.

It is preferable that an average primary particle diameter of the light diffusion particles is 100 nm to 20 µm, 100 nm to 10 µm is more preferable, and 200 nm to 2.5 µm is further preferable. The average primary particle diameter in the present embodiment is a D50 value measured by a laser diffraction particle size distribution analyzer. As examples of the laser diffraction particle size distribution measurement device, there are a laser diffraction particle size distribution measurement device from Shimadzu Corporation and the like.

It is preferable that the amount of the light diffusion particles contained in the light diffusion layer 12 is 0.5 to 30 mass% to the total mass of the light diffusion layer 12, and 1 to 15 mass% is more preferable. If the amount of the light diffusion particles is under 0.5 mass%, the light diffusiveness of the light diffusion layer 12 does not become sufficient, and there is a possibility that the light emitted from the light emitting member 10 could not be evened sufficiently. On the other hand, if the content of the light diffusion particles exceeds 30 mass%, there is a risk that optical transparency of the light diffusion layer 12 could decline and the light output efficiency of the LED devices 100 to 103 could decline.

The shape of the light diffusion particles is not especially limited, but from the viewpoint of diffusiveness and the like of the light diffusion particles, it is preferable that the light diffusion particles are spherical. The shape of the light diffusion particles is confirmable by a scanning electron microscope (SEM) and a transmission electron microscope (TEM).

### (Hardened material (binder) of organic silicon compound)

Hardened material of organic silicon compound is binder that binds the above light diffusion particles to one another. It is preferable that the amount of hardened material (binder) of organic silicon compound contained in the light diffusion layer 12 is 70 to 97 mass% to the total mass of the light diffusion layer, and 80 to 95 mass% is more preferable. If the amount of the hardened material of the organic silicon compound is under 70 mass%, there is a case where strength of the light diffusion layer does not become sufficient. On the other hand, if the content of the hardened material of the organic silicon compound exceeds 95 mass%, there is a case where the amount of the light diffusion particles decrease relatively and the light diffusiveness does not become sufficient.

The kind of the organic silicon compound is not especially limited, but (i) polysilazane oligomer or (ii) monomer or oligomer of silane compound is preferable.
(i) The polysilazane oligomer is represented by a general formula (I): (R¹R²SiNR³)ₙ. In the general formula (I), R¹, R², and R³ represent independently a hydrogen atom, or an alkyl group, an aryl group, a vinyl group, or a cycloalkyl group, respectively. However, at least one of R¹, R², and R³ is a hydrogen atom, and it is preferable that all of them are hydrogen atoms. The suffix n represents an integer of 1 to 60. A molecular shape of the polysilazane oligomer can be any shape, for example, a straight-chain shape or a cyclic shape.
   Hardened material of the polysilazane is obtained by applying heat treatment, excimer light treatment and UV light treatment to the polysilazane oligomer represented by the above formula (I) under the presence of reaction accelerator and solvent when necessary.
(ii) The silane compound or its oligomer can be monomer or oligomer of 2 functional silane compound, 3 functional silane compound, or 4 functional compound.

It is preferable that the binder (hardened material of organic silicon compound) of the light diffusion layer 12 is polymer (polysiloxane) of monomer of, especially, 3 functional silane compound and 4 function silane compound, or polymer (polysiloxane) of oligomer of the 3 functional silane compound and 4 function silane compound. If the binder is hardened material (polysiloxane) of copolymer of 3 functional silane compound and 4 functional silane compound, a film having high crosslink density is formed; accordingly, the strength of the light diffusion layer 12 rises. Besides, hydroxyl groups present on the coated surface and silicon in the polysiloxane form siloxane bonding; accordingly, adhesion between the coated surface and the light diffusion layer 12 rises. On the other hand, because of organic groups from the 3 functional silane compound remaining in the polysiloxane, also adhesion between the light diffusion layer 12 and the adhesive layer 21 and adhesion between the light diffusion layer 12 and the seal member 22 rise.

It is preferable that a polymerization ratio of the 3 functional silane compound and the 4 functional silane compound is 3:7 to 7:3, and 4:6 to 6:4 is more preferable. If the polymerization ratio of the 4 functional silane compound is excessive, a crosslinking degree of the polysiloxane rises excessively, and cracks become prone to occur in the light diffusion layer 12. Besides, the amount of the organic groups remaining in the polysiloxane becomes less, there is a risk that the adhesion between the light diffusion layer 12 and the adhesive layer 21 could not rise sufficiently. On the other hand, if the polymerization ratio of the 3 functional silane compound is excessive, a large amount of organic groups from the 3 functional silane compound remain in the polysiloxane. Because of this, there is a risk that the amount of the poysiloxane bond between hydroxyl groups present on the coated surface and silicon in the polysiloxane could become less and the adhesion between the light diffusion layer 12 and the coated surface could not become sufficient.

The binder (hardened material of organic silicon compound) of the light diffusion layer 12 can also be polymer (polysiloxane) of monomer of 2 functional silane compound and 3 function silane compound, or polymer (polysiloxane) of oligomer of the 2 functional silane compound and 3 function silane compound. It is preferable that a polymerization ratio of the 2 functional silane compound and the 3 functional silane compound is 1:9 to 4:6, and 1:9 to 3:7 is more preferable. If the polymerization ratio is in the above range, the amount of the polysiloxane bond between hydroxyl groups present on the surface of the glass substrate 11 and silicon in the polysiloxane is sufficient; accordingly, the adhesion between the light diffusion layer 12 and the glass substrate 11 rises sufficiently. On the other hand, because of organic groups from the 2 functional silane compound and 3 functional silane compound, the adhesion between the light diffusion layerb12 and the adhesive layer 21 rises sufficiently.

The binder (hardened material of organic silicon compound) of the light diffusion layer 12 can also be polymer of monomer of 2 functional silane compound, 3 function silane compound, and 4 functional silane compound, or polymer of oligomer of the 2 functional silane compound, 3 function silane compound, and 4 functional silane compound. It is preferable that a polymerization ratio of the 2 functional silane compound and the 3 functional silane compound is 1:9 to 4:6, and a polymerization ratio of the 4 functional silane compound to the polymer of the 2 functional silane compound and 3 functional silane compound is 9:1 to 7:3.

As an example of the 4 functional silane compound, there is compound represented by the following general formula (II):

Si(OR⁴)₄ (II)

In the above general formula (II), R⁴ represents independently an alkyl group or a phenyl group, preferably represents an alkyl group having a carbon number of 1 to 5 or a phenyl group having a carbon number of 1 to 5.

As specific examples of the 4 functional silane compound, there is alkoxysilane such as tetramethoxysilane, tetraethoxysilane, tetrapropoxysilanetetrabutoxysilane, tetrapentyloxysilane, tetraphenyloxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, monomethoxymonoethoxymonopropoxymonobutoxysilane and the like ; or aryloxysilane and the like. Among others, the tetramethoxysilane and tetraethoxysilane are preferable.

As an example of the 3 functional silane compound, there is compound represented by the following general formula (III):

R⁵Si (OR⁶)₃ (III)

In the above general formula (III), R⁵ represents independently an alkyl group or a phenyl group, preferably represents an alkyl group having a carbon number of 1 to 5 or a phenyl group having a carbon number of 1 to 5. Besides, R⁶ represents a hydrogen atom or an alkyl group.

As specific examples of the 3 functional silane compound, there are monohydrosilane compounds such as trimethoxysilane, triethoxysilane, tripropoxysilane, tripentyloxysilane, triphenyloxysilane, dimethoxymonoethoxysilane, diethoxymonomethoxysilane, dipropoxymonomethoxysilane, dipropoxymonoethoxysilane, dipentyloxylmonomethoxysilane, dipentyloxymonoethoxysilane, dipentyloxymonopropoxysilane, diphenyloxylmonomethoxysilane, diphenyloxymonoethoxysilane, diphenyloxymonopropoxysilane, methoxyethoxypropoxysilane, monopropoxydimethoxysilane, monopropoxydiethoxysilane, monobutoxydimethoxysilane, monopentyloxydiethoxysilane, monophenyloxydiethoxysilane and the like; monomethylsilane compounds such as methyltrimethoxysilane, methyltriethoxysilane, methyltripropoxysilane, methyltripentyloxysilane, methylmonomethoxydiethoxysi lane, methylmonomethoxydipropoxysilane, methylmonomethoxydipentyloxysilane, methylmonomethoxydiphenyloxysilane, methylmethoxyethoxypropoxysilane, methylmonomethoxymonoethoxymonobutoxysilane and the like; monoethylsilane compounds such as ethyltrimethoxysilane, ethyltripropoxysilane, ethyltripentyloxysilane, ethyltriphenyloxysilane, ethylmonomethoxydiethoxysilane, ethylmonomethoxydipropoxysilane, ethylmonomethoxydipentyloxysilane, ethylmonomethoxydiphenyloxysilane, ethymonomethoxymonoethoxymonobutoxysilane and the like; monopropylsilane compounds such as propyltrimethoxysilane, propyltriethoxysilane, propyltripentyloxysilane, propyltriphenyloxysilane, propylmonomethoxydiethoxysilane, propylmonomethoxydipropoxysilane, propylmonomethoxydiphenyloxysilane, propylmonomethoxydipentyloxysilane, propylmonomethoxydiphenyloxysilane, propylmethoxyethoxypropxyloxysilane, propylmonomethoxymonoethoxymonobutoxysilane and the like; and monbutylsilane compounds such as butyltrimethoxysilane, butyltriethoxysilane, butyltripropoxysilane, butyltripentyloxysilane, butyltriphenyloxysilane, butylmonomethoxydiethoxysilane, butylmonomethoxydipropoxysilane, butylmonomethoxydipentyloxysilane, butylmonomethoxydiphenyloxysilane, butylmethoxyethoxypropoxysilane, butylmonomethoxymonoethoxymonobutoxysilane and the like.

Among these 3 functional silane compounds, compounds, whose R⁵ represented by the general formula (III) is a methyl group, are preferable from the viewpoints of reactivity and the like. As examples of the 3 functional silane compound, there are methyltrimethoxysilane and methyltriethoxysilane, and the methyltrimethoxysilane is especially preferable.

As examples of the 2 functional silane compound, there is compound represented by the following general formula (IV):

R⁷₂ Si (OR⁸)₂ (IV)

In the above general formula (IV), R⁷ represents independently an alkyl group or a phenyl group, preferably represents an alkyl group having a carbon number of 1 to 5 or a phenyl group having a carbon number of 1 to 5. Besides, R⁸ represents a hydrogen atom or an alkyl group.

As specific examples of the 2 functional silane compound, there are dimethoxysilane, diethoxysilane, dipropoxysilane, dipentyloxysilane, diphenyloxysilane, methoxyethoxysilane, methoxypropoxysilane, methoxypentyloxysilane, methoxyphenyloxysilane, ethoxypropoxysilane, ethoxypentyloxysilane, ethoxyphenyloxysilane, methyldimethoxysilane, methylmethoxyethoxysilane, methyldiethoxysilane, methylmethoxypropoxysilane, methylmethoxypentyloxysilane, methylmethoxyphenyloxysilane, ethyldipropoxysilane, ethylmethoxypropoxysilane, ethyldipentyloxysilane, ethyldiphenyloxysilane, propyldimethoxysilane, propylmethoxyethoxysilane, propylethoxypropoxysilane, propyldiethoxysilane, propyldipentyloxysilane, propyldiphenyloxysilane, butyldimethoxysilane, butylmethoxyethoxysilane, butyldiethoxysilane, butylethoxypropoxysilane, butyldipropoxysilane, butylmethyldipentyloxysilane, butylmethyldiphenyloxysilane, dimethyldimethoxysilane, dimethylmethoxyethoxysilane, dimethyldiethoxysilane, dimethyldipentyloxysilane, dimethyldiphenyloxysilane, dimethylethoxypropoxysilane, dimethyldipropoxysilane, diethyldimethoxysilane, diethylmethoxypropoxysilane, diethyldiethoxysilane, diethylethoxypropoxysilane, dipropyldimethoxysilane, dipropyldiethoxysilane, dipropyldipentyloxysilane, dipropyldiphenyloxysilane, dibutyldimethoxysilane, dibutyldiethoxysilane, dibutyldipropoxysilane, dibutylmethoxypentyloxysilane, dibutylmethoxyphenyloxysilane, methylethyldimethoxysilane, methylethyldiethoxysilane, methylethyldipropoxysilane, methylethyldipentyloxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxyethoxysilane, dibutylmethoxypropoxysilane, dibutylethoxypropoxysilane and the like. Among these, the dimethoxysilane, diethoxysilane, methyldimethoxysilane, and methyldiethoxysilane are preferable.

The polysiloxane is obtained by applying heat treatment and the like to monomer or oligomer of the above silane compound under the presence of acid catalyst, water, and solvent when necessary.

### (Metal oxide microparticles)

The light diffusion layer 12 may contain metal oxide microparticles whose average primary particle diameter is under 100 nm. If the light diffusion layer 12 contains metal oxide microparticles, minuscule concaves and convexes occur on the surface of the light diffusion layer 12. These concaves and convexes can also form a surface roughness in the above range. Therefore, an anchor effect occurs between the light diffusion layer 12 and the adhesive later 21 or between the light diffusion layer 12 and the seal member 22, and the adhesion between the light diffusion layer 12 and the adhesive layer 21 or between the light diffusion layer 12 and the seal member 22 rises easily. Besides, gaps among the light diffusion particles contained in the light diffusion layer 12 are filled with the metal oxide microparticles; accordingly, the strength of the light diffusion layer 12 rises and cracks become unlikely to occur in the light diffusion layer 12.

The average primary particle diameter of the metal oxide microparticles is under 100 nm, 5 nm or larger to 100 nm or smaller is preferable, 5 to 80 nm is more preferable, and 5 to 50 nm is further preferable. If the average primary particle diameter of the metal oxide microparticles is under 100 nm, the metal oxide microparticles come to easily enter the gaps among the light diffusion particles, and the strength of the light diffusion layer 12 rises easily. Besides, if the average primary particle diameter of the metal oxide microparticles is 5 nm or larger, concaves and convexes producing a surface roughness in the above range are easily formed on the surface of the light diffusion layer 12, and the above anchor effect is easily obtained.

The kind of the metal oxide microparticles is not especially limited, but is preferably at least one kind selected from the group of zirconium oxide, titanium oxide, cerium oxide, niobium oxide, and zinc oxide. Especially, from the viewpoint that the film strength rises, it is preferable that zirconium oxide microparticles are contained. The light diffusion layer 12 may contain only one kind of metal oxide microparticles, or may contain two kinds or more.

The surface of the metal oxide microparticles may be treated by silane coupling agent or titanium coupling agent. If the surface of the metal oxide microparticles is treated, the metal oxide particles come to be easily dispersed evenly in the light diffusion layer 12.

It is preferable that the amount of the metal oxide microparticles contained in the light diffusion layer 12 is 1 to 30 mass% to the total mass of the light diffusion layer, 1 to 20 mass% is more preferable, and 2 to 10 mass% is further preferable. If the content of the metal oxide microparticles is under 1 mass%, the anchor effect at the interface between the light diffusion layer 12 and the layer formed on the light diffusion layer 12 and the film strength do not rise sufficiently. On the other hand, if the content of the metal oxide microparticles exceeds 30 mass%, the amount of the binder decreases relatively, and there is a risk that the film strength of the light diffusion layer 12 could decline.

### (Clay mineral)

The light diffusion layer 12 may contain clay mineral. If the light diffusion layer 12 contains clay mineral, the strength of the light diffusion layer 12 rises easily. As examples of the clay mineral, there are smectite group clay minerals such as natural or synthetic hectorite, saponite, stevensite, beidellite, montmorillonite, nontronite, bentonite and the like; swelling mica group clay minerals such as Na-type tetrasilicic fluoromica, Li-type tetrasilicic fluoromica, Na-type fluor-taeniolite, Li-type fluor-taeniolite and the like; vermiculite, kaolinite, and aluminum silicate compound, or mixtures of these. As to the clay mineral, a surface may be modified (surface treatment) by using ammonium salt or the like.

The aluminum silicate compound described here is hydrated aluminum silicate that uses silicon (Si), aluminum (Al), oxygen (O) and hydrogen (H) as main constituent elements and is assembled by many Si-O-Al bonds. For example, there is imogolite. And, it is preferable that the aluminum silicate compound has a tube shape whose outer diameter is 2.0 to 2.5 nm, inner diameter is 1.0 to 1.5 nm, and length is a few hundreds of nanometers.

It is preferable that the amount of the clay mineral contained in the light diffusion layer 12 is 0.3 to 20 mass% to the total mass of the light diffusion layer 12, and 0.5 to 15 mass% is more preferable. If the concentration of the clay mineral particles is under 0.5 mass%, there is a case where the strength of the light diffusion layer 12 does not rise sufficiently. On the other hand, if the concentration of the clay mineral particles exceeds 20 mass%, the amount of the light diffusion particles becomes less relatively, and there is a risk that sufficient light diffusion could not be obtained.

### (Hardened material of metal alkoxide or metal chelate)

The light diffusion layer 12 may contain hardened material of metal alkoxide or metal chelate of a metal element, except for a Si element, that has a valence of 2 or more. In the LED devices 100 to 103 of Figs. 1 to 4, if the light diffusion layer 12 contains hardened material of metal alkoxide or metal chelate, the adhesion between the light diffusion layer 12 and the coated surface rises. This is because metal contained in the metal alkoxide or metal chelate forms a metalloxane bond with a hydroxyl group and the like of the coated surface.

It is preferable that the amount of metal elements (except for the Si element) from the metal alkoxide or metal chelate contained in the light diffusion layer 12 is 0.5 to 20 mol% to a mol number of the Si element contained in the light diffusion layer, 1 to 10 mol% is more preferable. If the amount of the metal elements is under 05 mol%, the adhesion between the light diffusion layer 12 and the coated surface does not rise sufficiently. On the other hand, if the amount of the hardened material of the metal alkoxide or metal chelate increases, the amount of the light diffusion particles decreases relatively; accordingly, there is a risk that the light diffusiveness of the light diffusion layer 12 could decline. It is possible to calculate the amount of the metal elements and the amount of the Si element by using energy dispersive X-ray spectroscopy (EDX).

The kind of the metal element contained in the metal alkoxide or metal chelate is not especially limited if it is a metal element (except for Si) that has a valence of 2 or more, but is preferably an element of a group 4 or group 13. In other words, it is preferable that the metal alkoxide or metal chelate is specifically compound represented by the following general formula (V).

M^{m+}XₙYₘ₋ₙ (V)

In the general formula (V), M represents a metal element of a group 4 or group 13 and m represents a valence number (3 or 4) of M. X represents a hydrolyzable group and n represents the number (an integer of 2 or larger to 4 or smaller) of X groups, where m ≧ n. Y represents an organic group having a valence of 1.

In the general formula (V), it is preferable that the metal element of the 4 group or 13 group is aluminum, zirconium, or titanium, and the zirconium is especially preferable. Hardened material of alkoxide or chelate containing the zirconium element does not have an absorption wavelength in a light emission wavelength area (especially, blue light (wavelength of 420 to 485 nm)) of the general LED chip 2. Because of this, the light and the like from the LED chip 2 are not easily absorbed by the hardened material of the alkoxide or chelate of zirconium.

In the general formula (V), the hydrolyzable group represented by X can be a group that is hydrolyzed by water to generate a hydroxyl group. As preferable examples of the hydrolyzable group, there are a lower alkoxy group having a carbon number of 1 to 5, an acetoxy group, a butanone oxime group, a chloro group and the like. In the general formula (V), all the groups represented by X may be the same group or may be different groups.

As described above, the hydrolyzable group represented by X is hydrolyzed when the metal element cooperates with the the hydroxyl group and the like of the coated surface to form the metalloxane bond. Because of this, it is preferable that compound generated after the hydrolyzing is neutral and the group has a low boiling point. Accordingly, it is preferable that the group represented by X is a lower alkoxy group having a carbon number of 1 to 5, a methoxy group or an ethoxy group is more preferable.

In the general formula (V), the organic group having a valence of 1 represented by Y can be an organic group having a valence of 1 contained in general silane coupling agent. Specifically, the organic group can be an aliphatic group, an alicyclic group, an aromatic group, or an alicyclic aromatic group that has a carbon number of 1 to 1000, preferably 500 or smaller, more preferably 100 or smaller, further preferably 40 or smaller, especially preferably 6 or smaller. The organic group represented by Y may be a group formed by the aliphatic group, alicyclic group, aromatic group, and alicyclic aromatic group being bonded to one another via a linking group. The linking group may be an atom such as O, N, S or the like, or may be an atom group that contains these.

The organic group represented by Y may have a substituent group. As examples of the substituent group, there are halogen atoms such as F, C, I, Br, I and the like; and organic groups such as a vinyl group, a methacryloxy group, an acryloxy group, a styryl group, a mercapto group, an epoxy group, an epoxy cyclohexyl group, a glycidoxy group, an amino group, a cyano group, a nitro group, a sulfonate group, a carboxy group, a hydroxy group, an acyl group, an alkoxy group, an imino group, a phenyl group and the like.

As specific examples of the metal alkoxide or metal chelate that contains an aluminum element and is represented by the general formula (V), there are aluminum triisopropoxide, aluminum tri-n-butoxide, aluminum tri-t-butoxide, aluminum triethoxide and the like.

As specific examples of the metal alkoxide or metal chelate that contains a zirconium element and is represented by the general formula (V), there are zirconium tetramethoxide, zirconium tetraethoxide, zirconium tetra-n-propoxide, zirconium-tetra-i-propoxide, zirconium tetra-n-butoxide, zirconium tetra-i-butoxide, zirconium tetra-t-butoxide, zirconium dimethacrylatedibutoxide, dibutoxyzirconium bis (ethyl acetoacetate) and the like.

As specific examples of the metal alkoxide or metal chelate that contains a titanium element and is represented by the general formula (V), there are titanium tetraisopropoxide, titanium tetra-n-butoxide, titanium tetra-i-butoxide, titanium metacrylate triisopropoxide, titanium tetramethoxypropoxide, titanium tetra-n-propoxide, titanium tetraethoxide, titanium lactate, titanium bis (ethylhexoxy) bis (2-ethyl-3-hydroxyhexoxide), titanium acetylacetonate and the like.

However, the metal alkoxide or metal chelate indicated as examples in the above description is a part of organic metal alkoxide or metal chelate that is easily available in the market. Hardened material of the metal alkoxide or hardened material of the metal chelate indicated in a list of coupling agent and relevant products in the chapter 9 of "Optimum Use Technology of Coupling Agent" issued from National Institute of Advanced Industrial Science and Technology are also applicable to the present embodiment.

### ▪ Adhesive layer

The adhesive layer 21 is a layer that attaches the light emitting member 10 and the wavelength conversion▪light diffusion member 20 to each other. Specifically, it is a layer that attaches the light emitting member 10 and the wavelength conversion▪light diffusion member 20 to each other such that the wavelength conversion-light diffusion member 20 opposes the light output surface of the light emitting member 10. As shown in Fig. 1 or Fig. 3, the adhesive layer 21 may be formed into a frame shape between a periphery of a concave portion of the concave-shaped package 1, namely, an outer circumference of the light output surface of the light emitting member 10 and the wavelength conversion▪light diffusion member 20. Besides, as shown Fig. 2, the adhesive layer may be formed on a whole surface between the light emitting member 10 and the wavelength conversion▪light diffusion member 20. Besides, as shown in Fig. 4, the adhesive layer may be formed on a whole surface between the LED chip 2 and the wavelength conversion-light diffusion member 20. In Fig. 3, there is an air gap layer between the wavelength conversion▪light diffusion member 20 and the seal member 22, but the wavelength conversion▪light diffusion member 20 and the seal member 22 may be in tight contact with each other.

A thickness of the adhesive layer 21 is suitably selected in accordance with the structure and the like of the LED chip 2, but usually 0.05 to 0.3 µm is preferable, and 0.05 to 0.2 µm is more preferable. If the thickness of the adhesive layer 21 is too thin, there is a risk that the light emitting member 10 and the wavelength conversion ▪ light diffusion member 20 could not be sufficiently attached to each other. On the other hand, if the thickness of the adhesive layer 21 is too thick, there is a case where the optical transparency declines and the light output efficiency of the LED devices 100 to 102 declines.

The kind of the adhesive layer 21 is not especially limited, but can be an acryl-based, urethane-based, rubber-based, silicone-based adhesive layer or the like. The silicone-based adhesive layer is preferable from the viewpoint of adhesion between the light emitting member 10 and the wavelength conversion▪ light diffusion member 20, handleability and the like.

### ▪ Seal member

To prevent deterioration caused by moisture and oxygen in the air, the seal member 22 seals and shuts off the package 1 from an outside atmosphere. As the seal member 22, it is possible to use bisphenol A type and F type, and epoxy compound such as novolac resin and the like. It is possible to use a method in which epoxy compound and acid anhydride such as oxetane compound and the like are made to coexist; oxygen generator such as sulfonium salt, phosphonium salt or the like is used as initiator to polymerize the epoxy compound and the acid abhydride; and the polymer is left under a high temperature for a predetermined time to harden it.

### 2. Method for producing LED device

A method for producing the LED devices 100 to 103 of Figs. 1 to 4 includes the following steps.
1) A step for preparing a light emitting member that has a package, an LED chip mounted on this package, and a seal member that seals the LED chip when necessary.
2) A step for preparing a wavelength conversion▪light diffusion member that has a glass substrate, a light diffusion layer and a wavelength conversion layer that are formed on the glass substrate.
3) A step for forming an adhesive layer on the light emitting member and/or the wavelength conversion▪light diffusion member, stacking the light emitting member and the wavelength conversion▪light diffusion member, and bonding these to each other.

### 1) Preparation step of light emitting member

The preparation step of the light emitting member can be a step or the like in which (i) the LED chip is mounted on the package, and (ii) a seal member layer is formed onto the LED chip when necessary.
(i) A metal portion (wiring) of the package and the LED chip are electrically connected to each other, whereby the LED chip is mounted on the package. As described above, the LED chip and the metal portion may be connected to each other via a wiring or may be connected to each other via a protrusion electrode.
(ii) After the mounting of the LED chip, the seal member layer is formed to cover at least a light emitting surface of the LED chip.

### 2) Preparation step of wavelength conversion▪light diffusion member

The step for preparing the wavelength conversion▪light diffusion member can be a step for applying light diffusion layer forming composition, which contains the above light diffusion particles and the organic silicon compound, onto the glass substrate, and a step for applying wavelength conversion layer forming composition which contains the above fluorescent material particles and the binder. In the meantime, it is possible to decide which step to perform first in accordance with a layer structure of the wavelength conversion▪light diffusion member.

The light diffusion layer forming composition may contain the above metal oxide microparticles, clay mineral, metal alkoxide or metal chelate, solvent and the like besides the above organic silicon compound and the light diffusion particles.

It is preferable that the amount of the organic silicon compound contained in the light diffusion layer forming composition is 5 to 50 mass% to the total mass of the light diffusion layer forming composition. In the meantime, in a case where the organic silicon compound is oligomer of silane compound, the silane compound is polymerized to prepare the oligomer. A method for preparing the oligomer of the silane compound is described later.

The solvent contained in the light diffusion layer forming composition is not especially limited if the solvent can dissolve or disperse the organic silicon compound. For example, the solvent may be aqueous solvent that is excellent in compatibility with water, besides, may be non-aqueous solvent that has low compatibility with water.

It is preferable that a boiling point of the solvent contained in the light diffusion layer forming composition is 150°C or higher. If organic solvent having a boiling point of 150°C or higher is contained, preservation stability of the light diffusion layer forming composition improves, and it is possible to stably apply the light diffusion layer forming composition from an application device. On the other hand, from the viewpoint of drying property of the light diffusion layer forming composition, it is preferable that the boiling point of the solvent is 250°C or lower.

It is preferable that the solvent contained in the light diffusion layer forming composition contains polyhydric aliphatic alcohol having a valence of 2 or more. If polyvalent alcohol is contained, viscosity of the light diffusion layer forming composition rises, and the light diffusion particles and the like become unlikely to precipitate. As examples of the polyhydric aliphatic alcohol having a valence of 2 or more, there are for example ethylene glycol, propylene glycol, diethylene glycol, glycerin, 1, 3-butanediol, 1, 4-butanediol and the like.

It is preferable that the amount of the polyvalent alcohol contained in the light diffusion layer forming composition is 1 to 15 mass% to the whole light diffusion layer forming composition, 1 to 10 mass% is more preferable, and 3 to 10 mass% is further preferable.

The light diffusion layer forming composition may contain reaction accelerator along with organic silicon compound (especially, polysilazane olygomer). The reaction accelerator may be either one of acid and base. As examples of the reaction accelerator, there are amine such as triethylamine, diethylamine, N, N-diethylethanolamine, N, N-dimethylethanolamine, triethanolamine, triethylamine and the like; acid such as hydrochloric acid, oxalic acid, fumaric acid, sulfonic acid, acetic acid and the like; metal carboxylate and the like that contain nickel, iron, palladium, iridium, platinum, titanium, or aluminum. It is especially preferable that the reaction accelerator is metal carboxylate. It is preferable that an addition amount of the reaction accelerator is 0.01 to 5 mol% to the mass of the polysilazane oligomer.

An application method of the light diffusion layer forming composition is not especially limited, but as example of the application method, there are a bar coating method, a spin coating method, a spray coating method, a dispenser application method and the like.

As an example of a table coater used for the bar coating method, there is the TC-1 from MITSUI ELECTRIC CO., LTD. and the like, and as an example of a wire bar, there is a wire bar from TESTER SANGYO CO., LTD. and the like. A wire diameter of the wire bar is suitably selected in accordance with the film thickness of the light diffusion layer forming composition. Besides, an application speed of the table coater is suitably selected in accordance with the viscosity of the light diffusion layer forming composition and a desired thickness of the light diffusion layer, but generally can be set at 1 to 3 m/minute. Besides, in a case where the light diffusion layer forming composition is applied by using the table coater, it is preferable that a glass plate is placed on a coater base that has high flatness and the light diffusion layer forming composition is applied.

As an example of a spin coater used for the spin coating method, there is the spin coater MS-A100 from MIKASA CO., LTD. and the like. A revolution number of the spin coater is suitably selected in accordance with the viscosity of the light diffusion layer forming composition, the thickness of the light diffusion layer and the like, and generally can be set at about 300 rpm.

An example of a case where the light diffusion layer forming composition is applied onto the glass substrate 11 by using the spray coating method is described by using Fig. 8. Fig. 8 is a schematic view of a spray device for applying the light diffusion layer forming composition. In an application device 200 in Fig. 8, light diffusion layer forming composition 220 in an application liquid tank 210 is pressed to be supplied to a head 240 through a link pipe 230. The light diffusion layer forming composition 220 supplied to the head 240 is output from a nozzle 250 to be applied onto the glass substrate 11. The output of the application liquid from the nozzle 250 is performed by using wind pressure. A structure may be employed, in which an aperture portion freely openable and closable is disposed at a tip end of the nozzle 250 and on-off of the output work is controlled by performing an operation of opening and closing the aperture portion.

In the application step of the light diffusion layer forming composition, the following (1) to (4) operations and condition setting are performed.
(1) The tip end portion of the nozzle 250 is disposed right over the glass substrate 11 and light diffusion layer forming composition 270 is sprayed from right over the glass substrate 11.
(2) A spray amount of the light diffusion layer forming composition 220 is controlled in accordance with the viscosity of the light diffusion layer forming composition and a targeted film thickness. As long as the application is performed under the same condition, the spray amount is set constant and the application amount per unit area is set constant. Time-dependent unevenness of the spray amount of the light diffusion layer forming composition 220 is set to be within 10%, 1% or smaller is preferable. The spray amount of the light diffusion layer forming composition 220 is adjusted based on a relative movement speed of the nozzle 250 with respect to the glass substrate 11, a spray pressure from the nozzle 250 and the like. Generally, in a case where the viscosity of the light diffusion layer forming composition is high, the relative movement speed of the nozzle is slowed down and the spray pressure is set high. The relative movement speed of the nozzle is usually about 30 mm/s to about 200 mm/s, and the spray pressure is usually about 0.01 MPa to about 0.4 MPa.
   Besides, it is possible to adjust a drying state during the spray by adjusting the spray pressure; accordingly, it is possible to adjust the surface roughness. If the spray pressure is lowered, the light diffusion layer forming composition dries easily during the spray; accordingly, the surface roughness becomes large. On the other hand, if the spray pressure is lowered, the light diffusion layer forming composition is unlikely to dry during the spray; accordingly, the surface roughness becomes small. In the meantime, it is also possible to adjust the surface roughness by adjusting a distance between the nozzle 250 and the glass substrate 11. In this case, if the distance becomes long, the light diffusion layer forming composition dries easily during the spray; accordingly, the surface roughness becomes large. On the other hand, if the distance is shortened, the light diffusion layer forming composition is unlikely to dry during the spray; accordingly, the surface roughness becomes small.
(3) When applying the light diffusion layer forming composition 220, ambient atmosphere (temperature, humidity) for the application device 200 is set constant and the spray of the light diffusion layer forming composition 220 is stabilized. Especially, in a case where the organic silicon compound is polysilazane, the polysilazane has hygroscopicity; accordingly, there is a possibility that dispersion liquid 220 could solidify. Because of this, it is preferable to lower the humidity when spraying the light diffusion layer forming composition 220.
(4) The nozzle 250 may be cleaned during the spray▪application step. In this case, a cleaning tank storing cleaning solution is disposed near the application device 200. And, during suspension of the spray of the dispersion liquid 220 and the like, the tip end portion of the nozzle 250 is dipped into the cleaning tank to prevent the drying of the tip end portion of the nozzle 250. Besides, during suspension of the spray▪ application step, there is a risk that the light diffusion layer forming composition 220 could be hardened to clog a spray hole of the nozzle 250; accordingly, it is preferable to dip the nozzle 250 into the cleaning tank or to perform cleaning of the nozzle 250 at a start time of the spray▪application step.

Also in the case where the light diffusion layer forming composition is applied by using any method, after the application of the light diffusion layer forming composition, the solvent contained in the light diffusion layer forming composition is removed by drying. In addition, the organic silicon compound contained in the light diffusion layer forming composition is hardened by baking. It is preferable that a temperature when drying▪hardening the light diffusion layer forming composition is 20 to 200°C, and 25 to 150°C is more preferable. If the temperature is under 20°C, there is a possibility that the solvent could not sufficiently volatilize. On the other hand, if the temperature exceeds 200°C, there is a possibility that the LED chip could be adversely affected. Besides, it is preferable that the drying▪hardening period is 0.1 to 30 minutes in terms of production efficiency, 0.1 to 15 minutes is more preferable. In a case where the organic silicon compound is polysilazane oligomer, VUV radioactive rays (e.g., excimer light) in a wavelength range of 170 to 230 nm is directed to the coating film to harden the coating film, thereafter, further thermal hardening is performed, whereby a denser film is formed.

### (Method for preparing oligomer of silane compound)

It is possible to prepare the oligomer (polysiloxane oligomer) of the silane compound contained in the above light diffusion layer forming composition by using the following method. Monomer of the silane compound is hydrolyzed under the presence of acid catalyst, water, and organic solvent to make it undergo condensation reaction. A mass average molecular weight of the oligomer of the silane compound is adjusted based on a reaction condition (especially, reaction time) and the like.

The mass average molecular weight of the oligomer of the silane compound contained in the light diffusion layer forming composition is preferably 1000 to 3000, more preferably 1200 to 2700, and further preferably 1500 to 2000. If the mass average molecular weight of the oligomer of the silane compound contained in the light diffusion layer forming composition is under 1000, the viscosity of the light diffusion layer forming composition becomes low, and liquid splashing and the like become prone to occur during the forming period of the light diffusion layer. On the other hand, if the mass average molecular weight of the oligomer of the silane compound contained in the light diffusion layer forming composition exceeds 3000, there is a case where the viscosity of the light diffusion layer forming composition rises and it becomes hard to form an even film. The mass average molecular weight is a value (polystyrene conversion) measured by gel permeation chromatography.

The acid catalyst for preparing the oligomer of the silane compound functions as catalyst during the hydrolyzing period of the silane compound, and may be either one of organic acid and inorganic acid. As examples of the inorganic acid, there are sulfuric acid, phosphoric acid, nitric acid, hydrochloric acid and the like, and the phosphoric acid and nitric acid are especially preferable. Besides, as examples of the organic acid, there is compound, which has a carboxylate residue, such as formic acid, oxalic acid, fumaric acid, maleic acid, glacial acetic acid, acetic anhydride, propionic acid, n-butyric acid and like; and compound, which has a sulfur containing acid residue, such as organic sulfonic acid, ester compound (organic sulfuric acid ester, organic sulfurous acid ester) of organic sulfonic acid and the like.

It is especially preferable that the acid catalyst for preparing the oligomer of the silane compound is organic sulfonic acid represented by the following general formula (VI).

R⁸-SO₃H ··· (V)

In the above general formula (VI), the hydrocarbon group represented by R⁸ is a straight-chain, branched-chain, cyclic saturated or unsaturated hydrocarbon group having a carbon number of 1 to 20. As examples of the cyclic hydrocarbon group, there is an aromatic hydrocarbon group such as a phenyl group, a naphthyl group, an anthryl group or the like, and the phenyl group is preferable. Besides, the hydrocarbon group represented by R⁸ of the general formula (VI) may have a substituent group. As examples of the substituent group, there are a straight-chain, branched-chain, or cyclic saturated or unsaturated hydrocarbon group having a carbon number of 1 to 20; halogen atoms such as a fluorine atom and the like; a sulfonate group; a carboxyl group; a hydroxyl group; an amino group; a cyano group and the like.

It is preferable that the organic sulfonic acid represented by the above general formula (VI) is especially nonafluorobutanesulfonic acid, methanesulfonic acid, trifluoromethanesulfonic acid, or dodecyl benzenesulfonic acid.

It is preferable that the amount of the acid catalyst added during the preparation period of the oligomer of the silane compound is 1 to 1000 mass ppm to the total amount of the oligomer preparation liquid, and 5 to 800 mass ppm is more preferable.

Film quality of the obtained polysiloxane changes depending on the amount of the water added during the preparation period of the oligomer of the silane compound. Accordingly, it is preferable to adjust the water addition percentage during the preparation period of the oligomer in accordance with targeted film quality. The water addition percentage is a percentage (%) of the number of moles of the added water molecules to the number of moles of the alkoxy group or aryloxy group of the silane compound contained in the oligomer preparation liquid. It is preferable that the water addition percentage is 50 to 200%, and 75 to 180% is more preferable. By setting the water addition percentage at 50% or more, the film quality of the light diffusion layer stabilizes. Besides, by setting the water addition percentage at 200% or smaller, the preservation stability of the light diffusion layer forming composition becomes good.

As examples of the solvent added during the preparation period of the oligomer of the silane compound, there are monohydric alcohol such as methanol, ethanol, propanol, n-butanol and the like; alkyl carboxylate such as methyl-3-methoxypropionate, ethyl-3-ethoxypropionate and the like; polyhydric alcohol such as ethylene glycol, diethylene glycol, propylene glycol, glycerin, trimethylol propane, hexanetriol and the like; monoethers of polyhydric alcohol or monoacetates of these such as ethylene glycol monomethyl ether, ethylene glycol monoethyl ether, ethylene glycol monopropyl ether, ethylene glycol monobutyl ether, diethylene glycol monomethyl ether, diethylene glycol monoetyl ether, diethylene glycol monopropyl ether, diethylene glycol monobutyl ether, propylene glycol monomethyl ether, propylene glycol monoethyl ether, propylene glycol monopropyl ether, propylene glycol monobutyl ether and the like; esters such as methyl acetate, ethyl acetate, butyl acetate and the like; ketones such as acetone, methyl ethyl ketone, methyl isoamyl ketone and the like; and polyhydric alcohol ethers obtained by alkyl-etherifying all hydroxyl groups of polyhydric alcohol such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, diethylene glycol methyl ethyl ether and the like. As to these, one kind may be solely added, or two or more kinds may be added.

A forming method of the wavelength conversion layer is suitably selected based on the kind of the binder of the wavelength conversion layer and the like.
a) In a case where the binder is transparent resin, by applying wavelength conversion layer forming composition that contains the above fluorescent material particles, the above transparent resin or its precursor , and solvent, it is possible to form the wavelength conversion layer. As to the solvent contained in the wavelength conversion layer forming composition in the case where the binder is transparent resin, if the solvent can dissolve the above transparent resin or its precursor, the kind is not especially limited. As examples of the solvent, there are hydrocarbons such as toluene, xylene and the like; ketones such as acetone, methyl ethyl ketone and the like; ethers such as diethyl ether, tetrahydrofuran and the like; esters such as propylene glycol monomethyl ether acetate, ethyl acetate and the like.
   An application method of this wavelength conversion layer forming composition is not especially limited, but it is possible to use the same method as the application method of the above light diffusion layer forming composition.
   After the application of the wavelength conversion layer forming composition, the wavelength conversion layer forming composition is hardened. A hardening method and hardening condition of the wavelength conversion layer forming composition are suitably selected based on the kind of the transparent resin. As an example of the hardening method, there is thermal curing.
b) In a case where the binder is light-transmissive ceramic, by applying wavelength conversion layer forming composition that contains the above fluorescent material particles and precursor of the above light-transmissive ceramic and hardening the light-transmissive ceramic precursor, it is possible to form the wavelength conversion layer. The wavelength conversion layer forming composition contains the above clay mineral particles, inorganic particles, and solvent when necessary. If the above clay mineral particles and inorganic particles are contained, the viscosity of the wavelength conversion layer forming composition rises and the fluorescent material particles become unlikely to precipitate.

The solvent contained in the wavelength conversion layer forming composition in the case where the binder is light-transmissive ceramic can be water, organic solvent excellent in compatibility with water, further, organic solvent that has low compatibility with water. As examples of the solvent, there are univalent aliphatic alcohol such as methanol, ethanol, propanol, butanol and the like; and polyhydric alcohol having a valence of 2 or more such as ethylene glycol, propylene glycol, diethylene glycol, gricerin, 1, 3-butanediol, 1, 4-butanediol and the like.

It is preferable that a boiling point of the solvent is 150°C or higher. If organic solvent having a boiling point of 150°C or higher is contained, preservation stability of the wavelength conversion layer forming composition improves, and it is possible to stably apply the wavelength conversion layer forming composition from an application device. On the other hand, from the viewpoint of drying property of the wavelength conversion layer forming composition, it is preferable that the boiling point of the solvent is 250°C or lower.

Besides, the solvent may contain water. If water is contained, the above clay mineral particles swell, and the viscosity of the wavelength conversion layer forming composition rises more. However, if the water contains impurities, there is a risk that the impurities could hamper the swelling of the clay mineral particles. Because of this, it is preferable that the water contained in the solvent is pure water.

An application method of this wavelength conversion layer forming composition is not especially limited, but it is possible to use the same method as the application method of the above light diffusion layer forming composition.

After the application of the wavelength conversion layer forming composition, drying of the solvent and hardening of the light-transmissive ceramic precursor are performed. A temperature during the period of drying and hardening is usually 20 to 200°C, and 25 to 150°C is preferable. If the temperature is under 20°C, there is a possibility that the solvent could not sufficiently volatilize and the light-transmissive ceramic precursor is not hardened. On the other hand, if the temperature exceeds 200°C, there is a possibility that the LED chip could be adversely affected. Besides, the drying▪hardening period is usually 0.1 to 30 minutes in terms of production efficiency, and 0.1 to 15 minutes is preferable.
c) In the case where the binder is light-transmissive ceramic, the fluorescent material particles and the light-transmissive ceramic precursor may be divided into two liquids and applied. Specifically, fluorescent material dispersion liquid, which contains the above fluorescent material particles, clay mineral particles, inorganic particles, and solvent, is applied to form a fluorescent material layer; and, light-transmissive ceramic layer composition, which contains, the light-transmissive ceramic precursor and the solvent, is applied onto the fluorescent material layer to form a wavelength conversion layer.

The solvent contained in the fluorescent material dispersion liquid and in the light-transmissive ceramic layer composition can be the same solvent in the case where the fluorescent material particles and the light-transmissive ceramic precursor are applied with one liquid. Besides, an application method of the fluorescent material dispersion liquid, an application method of the light-transmissive ceramic composition, and a method of the drying▪hardening can be the same methods as in the case where these are applied with one liquid.

### 3) Forming step and attaching step of adhesive layer

After the forming of the above light emitting member and wavelength conversion-light diffusion member, an adhesive layer is formed on either one or both of them, to attach these to each other. For example, as shown in Figs. 1, 3, in a case of attaching the package 1 having the concave portion and the periphery of the wavelength conversion▪light diffusion member 20 to each other, the adhesive layer 21 is formed into a frame shape on either one or both of a periphery of the concave portion of the package 1 and the wavelength conversion-light diffusion member 20, and the light emitting member 10 and the wavelength conversion▪light diffusion member 20 are attached to each other. Besides, for example, as shown in Fig. 2, in a case of attaching a whole surface of an upper surface of the light emitting member 10 and the wavelength conversion-light diffusion member 20 to each other, the adhesive layer 21 is formed on either one or both of the light emitting member 10 and the wavelength conversion-light diffusion member 20, and the light emitting member 10 and the wavelength conversion▪light diffusion member 20 are attached to each other.

A forming method of the adhesive layer is not especially limited, but can be a known forming method of an adhesive layer. For example, an adhesion sheet obtained by forming adhesive into a film shape is prepared, and by attaching the adhesion sheet to the light emitting member and/or the wavelength conversion▪light diffusion member, the adhesive layer may be formed. Besides, the adhesive may be directly applied to the light emitting member and/or the wavelength conversion-light diffusion member. As examples of the method for directly applying the adhesive, there are application using a comma coater, printing using various kinds of printing methods, application using a spray coating applicator, application using a dispenser and the like.

After the attaching of the light emitting member 10 and the wavelength conversion▪light diffusion member 20, the adhesive is hardened when necessary. As examples of the hardening method of the adhesive, there are thermal curing, curing by directing ultraviolet rays and the like.

### Embodiments

Hereinafter, the present invention is described in more detail based on examples. However, the scope of the present invention is not limited at all by the description.

### (1) Preparation of package and LED chip

A package is prepared which is formed of polyphtalic acid amino (PPA) resin containing white pigment and is integrally formed with a lead frame. In the package, a concave portion having a conical trapezoidal shape, whose aperture diameter is 2.4 mm, wall surface angle is 45° and depth is 0.85 mm, is formed in a rectangular parallelepiped of 3.2 mm × 2.8 mm × 1.8 mm. An electrode portion disposed in the package and an LED chip are connected by using a gold wire, and the LED chip is mounted on the package. An outer shape of the LED chip is 305 µm × 330 µm × 100 µm. Besides, a peak wavelength of the LED chip is 475 nm.

### (2) Preparation of wavelength conversion layer forming composition

### ▪ Wavelength conversion layer forming composition A

3.25 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution. Thereafter, 6.5 g of yellow fluorescent material (the YAG 450C205 from NEMOTO & CO., LTD. (volume average particle diameter: particle diameter D50 20.5 µm)) is mixed with the polysiloxane solution to prepare wavelength conversion layer forming composition A.

### Wavelength conversion layer forming composition B

Organic silicon compound (the KER2600 from Shin-Etsu Chemical Co., Ltd.) and yellow fluorescent material (the YAG 450C205 from NEMOTO & CO., LTD. (volume average particle diameter: particle diameter D50 20.5 µm)) are mixed with each other to prepare wavelength conversion layer forming composition B. The concentration of the yellow fluorescent material of the wavelength conversion layer forming composition B is set at 5 mass%.

### (3) Production of LED device

### [Comparative example 1]

The wavelength conversion layer forming composition B is potted, by using a dispenser, into a concave portion of a package in which an LED chip is mounted. This is left at rest at 150°C for 2 hours to form a wavelength conversion layer, whereby a light emitting member is obtained which has the package, the LED chip, and the wavelength conversion layer.

### [Comparative example 2]

50 g of polyester resin (the VYLON220 from TOYOBO CO., LTD.) and dilution solvent (the G-004 solvent from Teikoku Printing Inks Mfg. Co., Ltd.) are mixed with each other to produce polyester resin solution. 100 g of the produced polyester resin solution, 5 g of isocyanate-based hardener (the 210 hardener from Teikoku Printing Inks Mfg. Co., Ltd.), 0.5 g of glass reinforcing agent (from Teikoku Printing Inks Mfg. Co., Ltd.), 1 g of anti-foaming agent (from Teikoku Printing Inks Mfg. Co., Ltd.), 5.6 g of silicon oxide microparticles (the SUNSPHERE NP-30 from Dohkai Chemical Industries Co., Ltd.), 7.8 g of acrylic resin microparticles (the MBX-8 from SEKISUI PLASTICS CO., LTD.), and 11.1 g of acryl-stylene copolymer microparticles (from SEKISUI PLASTICS CO., LTD.) are mixed with one another to prepare light diffusion layer forming composition.

The light diffusion layer forming composition is applied, by using the bar coating method, onto a glass substrate whose thickness is 100 µm and size is 100 mm × 100 mm. The light diffusion layer forming composition is dried under atmospheric pressure for 10 minutes at 120°C to produce a light diffusion member in which the glass substrate and the light diffusion layer are laminated. The film thickness of the light diffusion layer after the drying is 1 µm.

Adhesive (the LPS-5547 from Shin-Etsu Chemical Co., Ltd.) is applied onto the light diffusion layer of the light diffusion member to form an adhesive layer. Thereafter, the light diffusion layer of the light diffusion member and the wavelength conversion layer of the light emitting member produced in the comparative example 1 are attached to oppose each other, whereby an LED device is obtained.

### [Comparative example 3]

3.25 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution. Thereafter, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare wavelength conversion layer forming composition.

The light diffusion layer forming composition is applied, by using the bar coating method, onto a glass substrate whose thickness is 100 µm and size is 100 mm × 100 mm. The light diffusion layer forming composition is dried under atmospheric pressure for 1 hour at 150°C to produce a light diffusion member in which the glass substrate and the light diffusion layer are laminated. The film thickness of the light diffusion layer after the drying is 1 µm.

Adhesive (the LPS-5547 from Shin-Etsu Chemical Co., Ltd.) is applied onto the light diffusion layer of the light diffusion member to form an adhesive layer. The light diffusion layer of the light diffusion member and the wavelength conversion layer of the light emitting member produced in the comparative example 1 are attached to oppose each other, whereby an LED device is obtained.

### (Embodiment 1)

3.25 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare wavelength conversion layer forming composition.

The light diffusion layer forming composition is applied, by using the bar coating method, onto a glass substrate whose thickness is 100 µm and size is 100 mm × 100 mm. The light diffusion layer forming composition is dried under atmospheric pressure for 1 hour at 150°C to produce a light diffusion member in which the glass substrate and the light diffusion layer are laminated. The film thickness of the light diffusion layer after the drying is 1.5 µm.

The above light diffusion layer forming composition A is applied, by using the bar coating method, onto the light diffusion layer of the light diffusion member to a desired thickness. The light diffusion layer forming composition A is dried under atmospheric pressure for 1 hour at 150°C to produce a wavelength conversion▪light diffusion member shown in Fig. 5 in which the glass substrate, the light diffusion layer, and the wavelength conversion layer are laminated.

An LED chip is mounted onto a package to obtain a light emitting member. Adhesive (the LPS-5547 from Shin-Etsu Chemical Co., Ltd.) is applied onto an upper surface of the substrate of the package to form an adhesive layer. Thereafter, the wavelength conversion▪light diffusion member and the adhesive layer are attached to oppose each other, whereby the LED device shown Fig. 1 is obtained.

### (Embodiment 2)

7.0 g of polysilazane (the NN120 from AZ Electronic Materials; 20 mass% polysilazane, 80 mass% dibutyl ether), and 0.05 g of titanium oxide (the TA-100 from FUJI TITANIUM INDUSTRY CO., LTD, particle diameter 600 nm) are mixed with each other to prepare light diffusion layer forming composition. Thereafter, the LED device shown in Fig. 1 is obtained in the same way as in the embodiment 1.

### (Embodiment 3)

0.60 g of methyltrimethoxysilane, 2.60 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 2:8. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 4)

2.40 g of methyltrimethoxysilane, 0.65 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 8:2. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 5)

0.90 g of methyltrimethoxysilane, 2.40 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 3:7. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 6)

1.20 g of methyltrimethoxysilane, 1.85 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 4:6. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 7)

1.80 g of methyltrimethoxysilane, 1.30 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 8)

2.40 g of methyltrimethoxysilane, 0.65 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 4:6. Thereafter, 0.13 g of titanium oxide (the TA-100 from FUJI TITANIUM INDUSTRY CO., LTD, particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 9)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 4:6. Thereafter, 0.13 g of barium sulfate (the BF-10 from SAKAI CHEMICAL INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 10)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.3 g of zirconium oxide (ZrO₂) dispersion liquid (30 wt% methanol solution from SAKAI CHEMICAL INDUSTRY CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 11)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.3 g of zirconium oxide (ZrO₂) dispersion liquid (30 wt% methanol solution from SAKAI CHEMICAL INDUSTRY CO., LTD.) having an average primary particle diameter of 5 nm, 0.13 g of barium sulfate (the BF-10 from SAKAI CHEMICAL INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 12)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.3 g of aluminum silicate compound imogolite dispersion liquid synthesized as described below (water dispersion liquid of 0.3 wt% imogolite), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Synthesis of imogolite dispersion liquid that is aluminum silicate compound)

250 mL of 0.1 mol/L sodium orthosilicate and 250 mL of 0.15 mol/L aluminum chloride hexahydrate are mixed with each other in a container equipped with a stirrer of 1-L volume, and 50 mL of 1N sodium hydroxide aqueous solution is dropped in the mixed solution with the mixed solution being stirred. Here, the solution is heated by a plate heater at 90°C and this temperature is kept for 10 hours. Next, concentrated hydrochloric acid is added to set pH of the solution at 7.0. The generated sodium chloride is removed by water rinsing, concentrated hydrochloric acid is added to the solution again to obtain a pH of 4 , and the solution is heated to 100°C, and kept for 24 hours to produce imogolite dispersion liquid that is aluminum silicate compound.

### (Embodiment 13)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.09 g of BEN-GEL (natural bentonite from HOJUN Co., Ltd.), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 14)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.09 g of KUNIPIA F (natural montmorillonite from KUNIMINE INDUSTRIES CO., LTD.), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 15)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.09 g of SOMASIF (synthetic swelling mica from CO-OP CHEMICAL CO., LTD.), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 16)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.09 g of SWN (synthetic smectite from CO-OP CHEMICAL CO., LTD.), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 17)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 10 mass% acetylacetone (from KANTO CHEMICAL CO., INC.) to the total amount of the polysiloxane solution is added as stabilizer to the polysiloxane solution, and the ZC-580 (from Matsumoto Fine Chemical Co., Ltd.) is added as Zr chelate in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### (Embodiment 18)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added to the mixed liquid and stirred for 3 hours to obtain polysiloxane solution that contains polysiloxane of 3 functional component : 4 functional component = 4:6. Thereafter, 10 mass% acetylacetone (from KANTO CHEMICAL CO., INC.) to the total amount of the polysiloxane solution is added as stabilizer to the polysiloxane solution, and the ALR15GB (from Kojundo Chemical Laboratory Co., Ltd.) is added as A1 alkoxide in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### (Embodiment 19)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed with the above polysiloxane solution to prepare light diffusion layer forming composition.

The light diffusion layer forming composition is applied, by using the bar coating method, onto a glass substrate whose thickness is 100 µm and size is 100 mm × 100 mm. The light diffusion layer forming composition is dried under atmospheric pressure for 1 hour at 150°C to produce a light diffusion member in which the glass substrate and the light diffusion layer are laminated. The film thickness of the light diffusion layer after the drying is 1.5 µm.

The above light diffusion layer forming composition A is applied, by using the bar coating method, onto a glass substrate surface opposite to the light diffusion layer of the light diffusion member to a desired thickness. The light diffusion layer forming composition A is dried under atmospheric pressure for 1 hour at 150°C to produce a wavelength conversion▪light diffusion member shown in Fig. 6 in which the light diffusion layer, the glass substrate, and the wavelength conversion layer are laminated.

An LED chip is mounted onto a package to obtain a light emitting member. Adhesive (the LPS-5547 from Shin-Etsu Chemical Co., Ltd.) is applied onto an upper surface of the substrate of the package to form an adhesive layer. Thereafter, the wavelength conversion layer of the wavelength conversion▪light diffusion member and the adhesive layer are attached to oppose each other, whereby an LED device having the above (b) structure is obtained.

### (Embodiment 20)

1.20 g of methyltrimethoxysilane, 1.95 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 3 functional component : 4 functional component = 4:6. Thereafter, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed with the above polysiloxane solution to prepare light diffusion layer forming composition.

The above light diffusion layer forming composition A is applied, by using the bar coating method, onto a glass substrate whose thickness is 100 µm and size is 100 mm × 100 mm to a desired thickness. The light diffusion layer forming composition A is dried under atmospheric pressure for 1 hour at 150°C to produce a wavelength conversion member in which the wavelength conversion layer is laminated on the glass substrate.

The above light diffusion layer forming composition is applied, by using the spray coating method, onto the wavelength conversion layer of the wavelength conversion member. The light diffusion layer forming composition is dried under atmospheric pressure for 1 hour at 150°C to produce a wavelength conversion▪light diffusion member in which the glass substrate, the wavelength conversion layer, and the light diffusion layer are laminated. The film thickness of the light diffusion layer after the drying is 1.5 µm when a cross section is observed and measured by using a scanning electron microscope.

An LED chip is mounted onto a package to obtain a light emitting member. Adhesive (the LPS-5547 from Shin-Etsu Chemical Co., Ltd.) is applied onto an upper surface of the substrate of the package to form an adhesive layer. Thereafter, the wavelength conversion layer of the wavelength conversion▪light diffusion member and the adhesive layer are attached to oppose each other, whereby an LED device having the above (c) structure is obtained.

### (Embodiment 21)

In the wavelength conversion▪light diffusion member produced in the embodiment 19, the light diffusion layer and the adhesive layer are attached to oppose each other in a way opposite to the embodiment 19, whereby an LED device having the above (e) structure is obtained.

### (Embodiment 22)

In the wavelength conversion▪light diffusion member produced in the embodiment 10, the glass substrate and the adhesive layer are attached to oppose each other in a way opposite to the embodiment 10, whereby an LED device having the above (d) structure is obtained.

### (Embodiment 23)

In the wavelength conversion▪light diffusion member produced in the embodiment 20, the glass substrate and the adhesive layer are attached to oppose each other in a way opposite to the embodiment 20, whereby an LED device having the above (f) structure is obtained.

### [Evaluation]

As to the LED devices produced in the embodiments and comparative examples, chromaticity unevenness of light emitted from the LED devices, durability of the LED devices, presence of cracks occurring in the light diffusion layers, and adhesion of the light diffusion layers are evaluated.

### (Evaluation of chromaticity unevenness of light emitted from LED device)

A front surface of each of the LED devices produced in the embodiments and comparative examples is set at 0°, and light chromaticities (x value) at positions of 0° and ±70° are measured. The chromaticity measurement is performed by using a spectral radiance meter (the CS-1000A from Konica Minolta, Inc.). As to each LED device, differences between the chromaticity of the emitted light from the LED device front surface (0° ) and the chromaticities of the emitted light from the LED device sides (±70°) are calculated. These values are shown in a table 1. If the maximum value of the differences between the x values is 0.03 or larger, it is possible to evaluate that the chromaticity unevenness is large and harmful, and if the maximum value of the differences between the x values is under 0.03, it is possible to evaluate that the chromaticity unevenness is small and harmless.

### (Durability test of LED device)

As to the LED devices produced in the embodiments and comparative examples, each LED device is made to emit light by using an electric current value of 20 mA in a hot tank having a temperature of 150° for 1000 hours. As to the LED devices before and after the light emission, a total luminous flux value is measured. And, a ratio of the total luminous flux value after the 1000-hour light emission to the total luminous flux value before the 1000-hour light emission ((the total luminous flux value after the 1000-hour light emission/ the total luminous flux value before the 1000-hour light emission)×100) are calculated. These ratios are shown in the table 1. If the ratio is under 90%, it is possible to evaluate that deterioration is remarkable, and if the ratio is 90% or larger, it is possible to evaluate that there is almost no deterioration.

### (Presence of cracks occurring in light diffusion layer, and adhesion of the light diffusion layer)

As to the LED devices produced in the embodiments and comparative examples, a heat shock test is performed by using a heat shock tester to evaluate the presence of crack occurrence and the adhesion. In the heat shock test, a step is performed as one cycle in which the LED device is left at -40°C for 30 minutes, thereafter left at 100°C for 30 minutes, and 3000 cycles are performed. After the heat shock test, it is checked by using a microscope (the BX50 from OLYMPUS CORPORATION) whether or not cracks occur in the light diffusion layer and evaluation is performed as described below.

### Crack evaluation

- ×: Cracks occur, harmful.
- Δ: Cracks occur partially, but harmless.
- ○: Cracks occur slightly, but harmless.
- ⊚: No cracks

Besides, as to the LED devices after the heat shock test, it is checked by using a microscope (the BX50 from OLYMPUS CORPORATION) whether or not peeling occurs at the interface between the light diffusion layer and the adhesive layer, at the interface between the light diffusion layer and the glass substrate, or at the interface between the light diffusion layer and the wavelength conversion layer.

### Adhesion evaluation

- ×: Peeling occurs, harmful.
- Δ: Peeling occurs partially, but harmless.
- ○: Peeling occurs slightly, but harmless.
- ⊚: No peeling

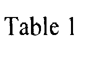

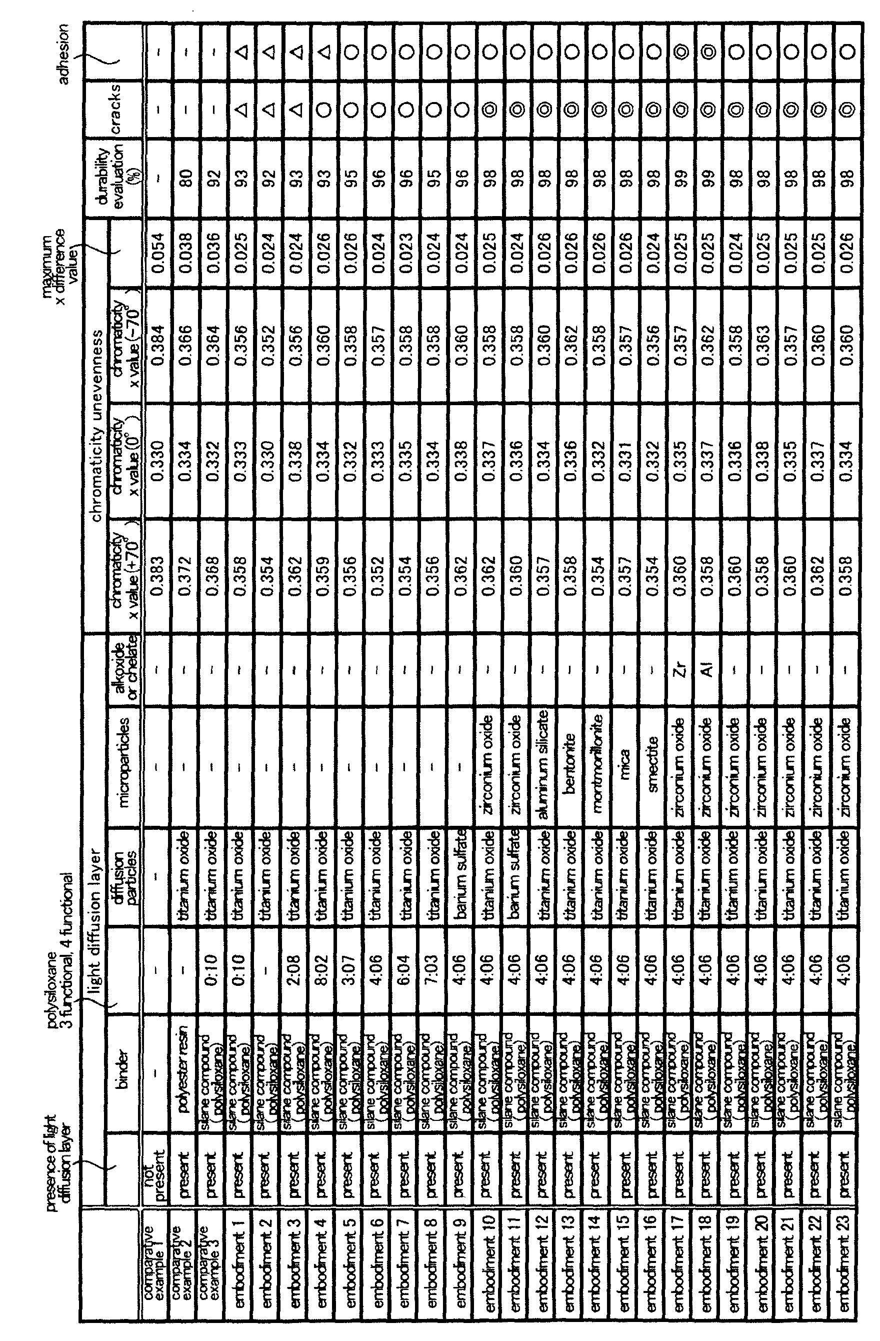

As shown in the table 1, in the cases (comparative examples 1 to 3) where the wavelength conversion layer is formed in the concave portion of the package, the chromaticity unevenness (x value difference) is large. It is inferred that in the case where the wavelength conversion layer is packed in the concave portion of the package, the specific gravity of the fluorescent material particles contained in the wavelength conversion layer is larger than the specific gravity of the transparent resin; accordingly, during the forming period of the wavelength conversion layer, the fluorescent material particles precipitate before the transparent resin is hardened and the concentration of the fluorescent material particles does not become even.

In contrast to this, if the wavelength conversion▪light diffusion member is disposed on the light emitting member (embodiments 1 to 23), the light from the light emitting member is diffused by the wavelength conversion▪light diffusion member and the chromaticity unevenness is curbed. To form the wavelength conversion layer on the glass substrate (on the light diffusion layer formed on the glass substrate), the high-density wavelength conversion layer forming composition is applied. Because of this, it is inferred that the high-density wavelength conversion layer is formed; accordingly, the wavelength conversion layer, whose concentration of the fluorescent material particles is even, is obtained and the light having the even chromaticity is emitted.

Besides, in the case (comparative example 2) where the binder of the light diffusion layer is the polyester resin, after the durability test, the total luminous flux value declines dramatically. It is inferred that the light diffusion layer deteriorates because of the durability test and the optical transparency of the light diffusion layer declines; accordingly, the total luminous flux value after the durability test declines. In contrast to this, in the cases (embodiments 1 to 23 and comparative example 3) where the binder of the light diffusion layer is the hardened material of the organic silicon compound, the total luminous flux value remains almost the same even after the durability test.

Besides, in the cases (embodiments 1 and 2) where the binder of the light diffusion layer is the hardened material of the 4 functional silane compound and in the case (embodiment 3) where the polymerization ratio of the 3 functional silane compound and the 4 functional silane compound is 2:8, cracks occur in the light diffusion layer. It is inferred that if there is much 4 functional component, the crosslink density is excessively high and the light diffusion layer cannot follow the swelling and the like of the glass substrate, so that the cracks occur. Besides, it is also considered as one reason for the cracks that the shrinking amount during the hardening period is large. Besides, in these examples, peeling occurs partially at the interface between the wavelength conversion layer and the light diffusion layer. It is inferred that the adhesion at these interfaces is insufficient.

On the other hand, in the case (embodiment 4) where the polymerization ratio of the 3 functional silane compound and the 4 functional silane compound is 8:2, peeling occurs partially at the interface between the glass substrate and the light diffusion layer. It is inferred that there is a large amount of organic groups contained in the light diffusion layer and the adhesion between the glass substrate and the light diffusion layer is insufficient.

In contrast to this, in the cases (embodiments 5 to 23) where the polymerization ratio of the 3 functional silane compound and the 4 functional silane compound is 3:7 to 7:3, peeling does not occur at any one of the interface between the glass substrate and the light diffusion layer, the interface between the light diffusion layer and the adhesive layer, and the interface between the light diffusion layer and the wavelength conversion layer. Besides, especially in the cases (embodiments 10 to 23) where the metal oxide microparticles are contained in the light diffusion layer, cracks do not occur. It is inferred that the gaps between the binder and the light diffusion particles are clogged by the metal oxide microparticles and the strength of the light diffusion layer rises. Besides, further, if the hardened material of metal alkoxide or metal chelate is contained in the light diffusion layer (embodiments 17 and 18), the adhesion between the glass substrate and the light diffusion layer or the adhesion between the wavelength conversion layer and the light diffusion layer rise. It is conceived that the metal contained in the metal chelate forms strong metalloxane bonding with the hydroxyl groups and the like of the coated surface; accordingly, the good adhesion is obtained.

### (Embodiment 24)

0.3 g of dimethyldimethoxysilane, 3.06 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 1:9. Thereafter, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 25)

The LED device shown in Fig. 1 is obtained in the same way as in the embodiment 24 except that the titanium oxide in the embodiment 24 is changed to barium sulfate (the BF-10 from SAKAI CHEMICAL INDUSTRY CO., LTD., particle diameter 600nm).

### (Embodiment 26)

0.6 g of dimethyldimethoxysilane, 2.6 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 27)

0.9 g of dimethyldimethoxysilane, 2.4 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 3:7. Thereafter, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 28)

1.2 g of dimethyldimethoxysilane, 1.85 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 4:6. Thereafter, 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 29)

0.28 g of dimethyldimethoxysilane, 2.22 g of methyltrimethoxysilane, 0.71 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component : 4 functional component = 1:7:2. Thereafter, 0.14 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 30)

The LED device shown in Fig. 1 is obtained in the same way as in the embodiment 29 except that the titanium oxide in the embodiment 29 is changed to barium sulfate (the BF-10 from SAKAI CHEMICAL INDUSTRY CO., LTD., particle diameter 600nm).

### (Embodiment 31)

0.3 g of dimethyldimethoxysilane, 2.85 g of methyltrimethoxysilane, 0.4 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component : 4 functional component = 1:8:1. Thereafter, 0.14 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 32)

0.2 g of dimethyldimethoxysilane, 1.3 g of methyltrimethoxysilane, 0.7 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component : 4 functional component = 1:6:3. Thereafter, 0.14 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 33)

0.6 g of dimethyldimethoxysilane, 2.6 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 0.3 g of dispersion liquid 30 mass% isopropyl alcohol solution (the ZRPA30WT%-E11 from CIK NanoTek Corporation) of zirconium oxide (ZrO₂), 0.13 g of titanium oxide (the TA-100 from FUJI TITANIUM INDUSTRY CO., LTD., particle diameter 600 nm) and 2 g of 1, 3-butanediol are mixed with the polysiloxane solution to prepare light diffusion layer forming composition. Thereafter, the LED device shown in Fig. 1 is obtained in the same way as in the embodiment 1.

### (Embodiment 34)

The LED device shown in Fig. 1 is obtained in the same way as in the embodiment 33 except that the titanium oxide in the embodiment 33 is changed to barium sulfate (the BF-10 from SAKAI CHEMICAL INDUSTRY CO., LTD., particle diameter 600nm).

### (Embodiment 35)

The LED device shown in Fig. 1 is obtained in the same way as in the embodiment 33 except that the zirconium oxide in the embodiment 33 is changed to aluminum silicate compound. In the meantime, the aluminum silicate compound is obtained in the same way as in the embodiment 12.

### (Embodiment 36)

The LED device shown in Fig. 1 is obtained in the same way as in the embodiment 33 except that the zirconium oxide in the embodiment 33 is changed to KUNIPIA F (natural montmorillonite from KUNIMINE INDUSTRIES CO., LTD.).

### (Embodiment 37)

0.6 g of dimethyldimethoxysilane, 2.6 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 10 mass% acetylacetone (from KANTO CHEMICAL CO., INC.) to the total amount of the polysiloxane solution is added as stabilizer to the polysiloxane solution, and the ZC-580 (from Matsumoto Fine Chemical Co., Ltd.) is added as Zr chelate in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### (Embodiment 38)

0.6 g of dimethyldimethoxysilane, 2.6 g of methyltrimethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 10 mass% acetylacetone (from KANTO CHEMICAL CO., INC.) to the total amount of the polysiloxane solution is added as stabilizer to the polysiloxane solution, and the ALR15GB (from Kojundo Chemical Laboratory Co., Ltd.) is added as Al alkoxide in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### (Embodiment 39)

0.28 g of dimethyldimethoxysilane, 2.22 g of methyltrimethoxysilane, 0.71 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 0.3 g of dispersion liquid 30 mass% isopropyl alcohol solution (the ZRPA30WT%-E11 from CIK NanoTek Corporation) of zirconium oxide (ZrO₂), 0.13 g of titanium oxide (the TA-100 from FUJI TITANIUM INDUSTRY CO., LTD., particle diameter 600 nm) and 2 g of 1, 3-butanediol are mixed to prepare light diffusion layer forming composition. Thereafter, the LED device shown in Fig. 1 is obtained in the same way as in the embodiment 1.

### (Embodiment 40)

The LED device shown in Fig. 1 is obtained in the same way as in the embodiment 39 except that the titanium oxide in the embodiment 39 is changed to barium sulfate (the BF-10 from SAKAI CHEMICAL INDUSTRY CO., LTD., particle diameter 600nm).

### (Embodiment 41)

The LED device shown in Fig. 1 is obtained in the same way as in the embodiment 40 except that the zirconium oxide in the embodiment 40 is changed to aluminum silicate compound. In the meantime, the aluminum silicate compound is obtained in the same way as in the embodiment 12.

### (Embodiment 42)

The LED device shown in Fig. 1 is obtained in the same way as in the embodiment 41 except that the zirconium oxide in the embodiment 41 is changed to KUNIPIA F (natural montmorillonite from KUNIMINE INDUSTRIES CO., LTD.).

### (Embodiment 43)

0.28 g of dimethyldimethoxysilane, 2.22 g of methyltrimethoxysilane, 0.71 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 10 mass% acetylacetone (from KANTO CHEMICAL CO., INC.) to the total amount of the polysiloxane solution is added as stabilizer to the polysiloxane solution, and the ZC-580 (from Matsumoto Fine Chemical Co., Ltd.) is added as Zr chelate in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### (Embodiment 44)

0.28 g of dimethyldimethoxysilane, 2.22 g of methyltrimethoxysilane, 0.71 g of tetramethoxysilane, 4.00 g of methanol, and 4.00 g of acetone are mixed and stirred with one another. Further, 5.46 g of water and 4.7 µL of 60% nitric acid are added and stirred for 3 hours to obtain polysiloxane solution that contains polysiloxane of 2 functional component : 3 functional component = 2:8. Thereafter, 10 mass% acetylacetone (from KANTO CHEMICAL CO., INC.) to the total amount of the polysiloxane solution is added as stabilizer to the polysiloxane solution, and the ALR15GB (from Kojundo Chemical Laboratory Co., Ltd.) is added as Al alkoxide in such a way that its solid content amount becomes 10 mass% to solid content of light diffusion layer forming composition. Further, 0.3 g of zirconium oxide (ZrO₂) dispersion liquid (30 wt% methanol solution from SAKAI CHEMICAL CO., LTD.) having an average primary particle diameter of 5 nm, 0.13 g of titanium oxide (the TA-100 from FUJI TITANIUM INDUSTRY CO., LTD., particle diameter 600 nm) and 2 g of 1, 3-butanediol are mixed to prepare the light diffusion layer forming composition. Thereafter, the LED device shown in Fig. 1 is obtained in the same way as in the embodiment 1.

### [Evaluation]

As to the LED devices produced in the embodiments 24 to 44, chromaticity unevenness of light emitted from the LED devices, durability of the LED devices, and adhesion of the light diffusion layers are evaluated in the same way as in the embodiment 1. The results are shown in a table 2.

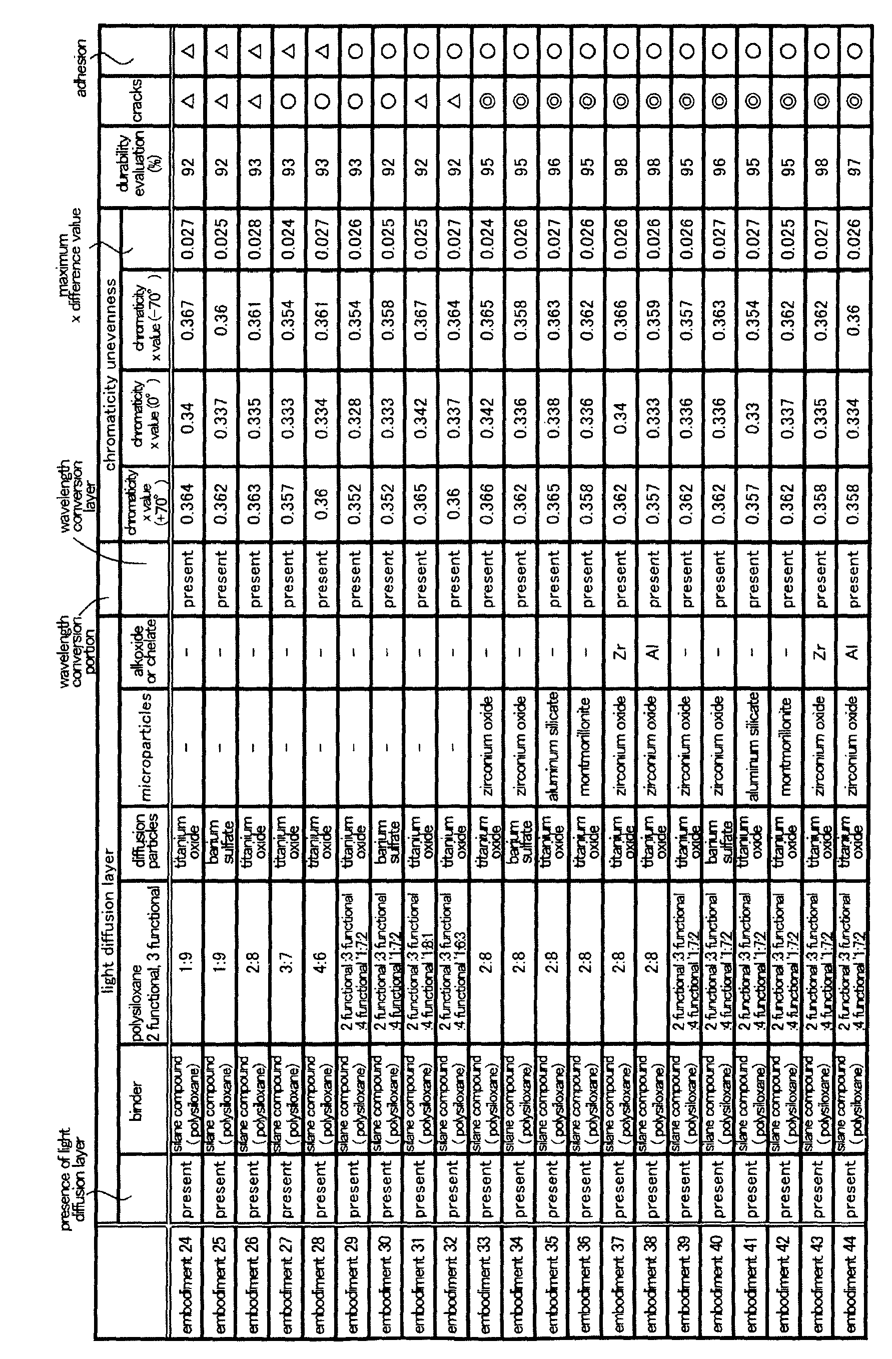

### Industrial Applicability

The light emitting device according to the present invention has a little chromaticity unevenness of the emitted light. Because of this, the light emitting device according to the present invention is suitable to car headlights that require the evenness of emitted light and various kinds of illumination devices that are used indoors and outdoors.

### Reference Signs List

- 1: package
- 3: LED chip (light emitting element)
- 4: wavelength conversion layer
- 12: light diffusion layer
- 20: wavelength conversion-light diffusion member
- 100 to 103: LED devices (light emitting devices)

## Claims

1. A light emitting device comprising:
a light emitting member that has a package and a light emitting element mounted on the package, and
a wavelength conversion-light diffusion member that has a glass substrate, a wave length conversion layer and a light diffusion layer which are formed on the glass substrate, wherein
the wavelength conversion layer contains a fluorescent material particle, and
the light diffusion layer contains a light diffusion particle and a hardened material of organic silicon compound.

2. The light emitting device according to claim 1, wherein
the organic silicon compound is formed of polymer of 3 functional silane compound and 4 functional silane compound, and
a polymerization ratio of the 3 functional silane compound and the 4 functional silane compound is 3:7 to 7:3.

3. The light emitting device according to claim 1, wherein
the organic silicon compound is formed of polymer of 2 functional silane compound and 3 functional silane compound, and
a polymerization ratio of the 2 functional silane compound and the 3 functional silane compound is 1:9 to 4:6.

4. The light emitting device according to claim 1, wherein
the organic silicon compound is formed of polymer of 2 functional silane compound, 3 functional silane compound, and 4 functional silane compound,
a polymerization ratio of the 2 functional silane compound and the 3 functional silane compound is 1:9 to 4:6, and
a polymerization ratio of the 4 functional silane compound to polymer of the 2 functional silane compound and the 3 functional silane compound is 9:1 to 7:3.

5. The light emitting device according to any one of claims 1 to 4, wherein
the light diffusion particle is at least one kind selected from the group of titanium oxide, barium sulfate, barium titanate, boron nitride, zinc oxide, and aluminum oxide.

6. The light emitting device according to any one of claims 1 to 5, wherein
the light diffusion layer contains metal oxide microparticles whose average primary particle diameter is under 100 nm.

7. The light emitting device according to any one of claims 1 to 6, wherein
the metal oxide microparticles are at least one kind selected from the group of zirconium oxide, titanium oxide, cerium oxide, silicon oxide, niobium oxide, and zinc oxide.

8. The light emitting device according to any one of claims 1 to 7, wherein
the light diffusion layer contains clay mineral.

9. The light emitting device according to claim 8, wherein
the clay mineral is aluminum silicate compound.

10. The light emitting device according to any one of claims 1 to 9, wherein
the light diffusion layer contains hardened material of metal alkoxide or metal chelate that contains a metal element (except for Si) having a valence of 2 or more.

11. The light emitting device according to any one of claims 1 to 10, wherein
the wavelength conversion layer contains hardened material of organic silicon compound.

12. The light emitting device according to any one of claims 1 to 10, wherein
the wavelength conversion layer contains transparent resin.
